# EUROPÄISCHE PATENTSCHRIFT

(11) **EP 3 942 307 B1**
(45) Veröffentlichungstag und Bekanntmachung des Hinweises auf die Patenterteilung: **25.02.2026**
(21) Anmeldenummer: 20713552.6
(22) Anmeldetag: 19.03.2020
(51) Int. Cl.: G01R 19/165, G01R 19/12

(54) **VORRICHTUNG ZUR ANALYSE VON STRÖMEN IN EINEM ELEKTRISCHEN VERBRAUCHER UND VERBRAUCHER MIT EINER DERARTIGEN VORRICHTUNG**
APPARATUS FOR ANALYSING CURRENTS IN AN ELECTRICAL LOAD, AND LOAD HAVING SUCH AN APPARATUS
DISPOSITIF D'ANALYSE DES COURANTS DANS UN CONSOMMATEUR ÉLECTRIQUE ET CONSOMMATEUR ÉQUIPÉ D'UN TEL DISPOSITIF

(30) Priorität: 20.03.2019 DE 102019107135
(43) Veröffentlichungstag der Anmeldung: 26.01.2022
(73) Patentinhaber: Elmos Semiconductor SE, 51379 Leverkusen (DE)
(72) Erfinder: KRUPAR, Jörg, 01833 Stolpen (DE); FIEDLER, Michael, 01259 Dresden (DE); WAGENKNECHT, Christian, 01219 Dresden (DE)
(74) Vertreter: dompatent
(86) Internationale Anmeldenummer: PCT/EP2020/057675
(87) Internationale Veröffentlichungsnummer: WO 2020/188054

(56) Entgegenhaltungen:
- DE-A1- 4 234 421
- US-A1- 2003 034 770
- US-A1- 2014 142 724
- US-A1- 2014 333 294
- GAJULA KAUSHIK K ET AL: "Detection of Series DC Arc on a Distribution Node using Discrete-Time Parameter Identification Techniques", 2019 IEEE APPLIED POWER ELECTRONICS CONFERENCE AND EXPOSITION (APEC), IEEE, 17 March 2019 (2019-03-17), pages 3007 - 3012, XP033555090, DOI: 10.1109/APEC.2019.8722050

## Beschreibung

Die Erfindung richtet sich auf Vorrichtung zum geschalteten Ansteuern von mehreren Lasten mittels Schaltelementen.

Im Zuge der Elektromobilität wird die sichere Ansteuerung elektrischer Verbraucher im Fahrzeug immer wichtiger. Gerade bei großen ohmschen Lasten ist nicht immer der Fehlerzustand klar vom Normalbetrieb zu unterscheiden. Außerdem steigt durch die größeren Energien die EMV-Abstrahlung. Die vorliegende Erfindung kann aber auch anderweitig eingesetzt werden. Die hier vorgestellte Erfindung beansprucht auch die Nutzung von KI-Technologien für die Steuerung solcher Vorrichtungen.

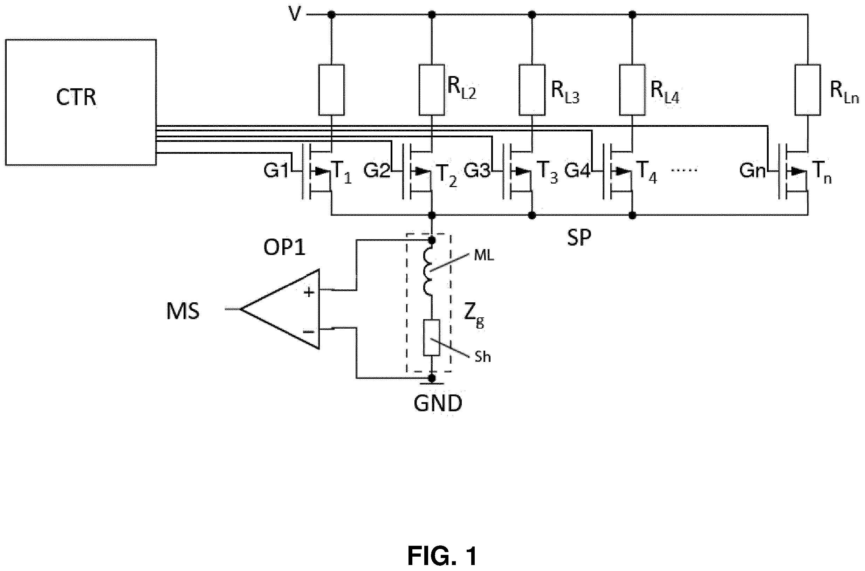

Im Stand der Technik existieren eine Reihe von Systemen mit der Struktur entsprechend Fig. 1.

Fig. 1 zeigt schematisch die Schaltung eines elektrischen Verbrauchers mit mehreren, d.h. n Lastzweigen (mit n als ganzer positiver Zahl größer gleich 1), deren jeweilige Lasten RL1 bis RLn periodisch durch eine Schaltsignalerzeugungseinheit CTR mit Schaltelementen T₁ bis Tₙ, hier beispielhaft n Transistoren, ein- und ausgeschaltet werden, um deren mittlere Leistung zu steuern.

Die n Schaltelemente T₁ bis Tₙ erhalten entsprechende Ansteuersignale G1 bisGn. Diese n Ansteuersignale G1 bisGn werden in einer entsprechenden Schaltsignalerzeugungseinheit CTR erzeugt. In der Regel werden die Ansteuersignale G1 bis Gn gegeneinander zeitlich verschoben durch die Schaltsignalerzeugungseinheit CTR erzeugt, um eine möglichst konstante mittlere Stromaufnahme an der Versorgung V zu generieren.

In den Systemen entsprechend der Fig. 1 ist oftmals zwischen dem Sternpunkt SP der parallel geschalteten Lastzweige und dem Bezugspotenzial GND eine Strommessung mit einem gemeinsamen Strommesselement Z_{g} und einem entsprechenden Strommesspfad vorhanden. Dieses Strommesselement Z_{g} wird z.B. benutzt, um die mittlere Stromaufnahme des Verbrauchers in Form eines Stromaufnahmemesswerts des Strommesssignals MS zu messen. Das gemeinsame Strommesselement Z_{g} wird typischerweise durch zeitlich geschickte Steuerung dazu benutzt, bei einer vordefinierbaren Phasenlage des Messzeitpunkts zur Ansteuerperiode Messungen der Stromaufnahmen der einzelnen Lastzweige gezielt für Regelungszwecke vorzunehmen.

Anwendungen derartiger Systeme sind z.B. mehrphasige DC/DC-Wandler, Glühkerzensteuerungen für mehrere Glühkerzen oder auch elektrische Heizungen mit mehreren Heizelementen.

In der Regel enthält der Strommesspfad neben einem Verstärker OP1 noch ein Tiefpassfilter, um die durch die Schaltflanken erzeugten Störungen aus dem Messungssignal zu eliminieren.

Eine Vorrichtung nach dem Oberbegriff des Anspruchs 1 ist aus US-A-2014/0142724 bekannt.

In DE-A-42 34 421 ist eine Vorrichtung zur stromgeregelten Steuerung mehrerer Stellglieder mittels eines Steuercomputers beschrieben.

Aus DE-A-100 41 880 ist ein Verfahren zum getakteten Betreiben von mindestens zwei elektrischen Verbrauchern entsprechend einem Zeitschema bekannt.

Aus EP-A-0 198 222 ist ein Lastverteilungsverfahren für elektrische Verbraucher bekannt.

Aus DE-A-10 2020 033 633 sind ein Einschalt-Steuerungsverfahren und eine Einschalt-Steuerungsvorrichtung bekannt.

Aufgabe der Erfindung ist es, eine vereinfachte Vorrichtung zur Analyse von Strömen in den Lastzweigen eines mehrphasigen elektrischen Verbrauchers anzugeben.

Zur Lösung dieser Aufgabe wird mit der Erfindung eine Vorrichtung zur Analyse von Strömen in einem elektrischen Verbraucher vorgeschlagen, der versehen ist mit
- einer Parallelschaltung aus mehreren Lastzweigen,
- wobei jeder Lastzweig eine elektrische Last und ein diese wahlweise ein- oder ausschaltbares, steuerbares Schaltelement aufweist und
- einer Ansteuereinheit zur Erzeugung von Ansteuersignalen für die Schaltelemente,
wobei die Vorrichtung versehen ist mit den Merkmalen des Anspruchs 1.

Einzelne Ausgestaltungen der Erfindung sind Gegenstand der Unteransprüche.

Die erfindungsgemäße Vorrichtung weist ein für mehrere Lastzweige der Parallelschaltung eines mehrphasigen elektrischen Verbrauchers gemeinsames Strommessmittel auf, mit dem sich der jeweils durch die Parallelschaltung fließende Strom messtechnisch ermitteln lässt. Die Lastzweige werden dabei zyklisch ein- und ausgeschaltet, wobei sich im allgemeinen Änderungen des Gesamtstroms ergeben, die mittels eines Detektors detektierbar sind. Eine Analyseeinheit erhält Informationen von der Ansteuereinheit, die die Ein- und Ausschaltsignale für die Schaltelemente der Lastzweige generiert, und von dem Detektor. Aufgrund der zeitlichen Korrelation des Ein- und Ausschaltens eines oder mehrerer der Schaltelemente mit der Detektion einer Veränderung des Gesamtstroms lässt sich nun untersuchen, ob der elektrische Verbraucher ordnungsgemäß arbeitet oder fehlerhaft. Diese Untersuchung können zusätzlich auch durch Analyse der Art und Weise der Veränderung des Stroms zu mehreren Zeitpunkten eines Einschaltens und Ausschaltens eines Schaltelements bzw. mehrerer Schaltelemente des Verbrauchers durchgeführt werden.

Eine Veränderung der zeitlichen Korrelation zwischen dem Einschalten eines Lastzweiges (oder auch dessen Ausschalten) und dem Auftreten der Veränderung des Stroms, detektiert durch den Detektor, kann Aufschluss über eine Veränderung des Betriebs oder des Zustands des elektrischen Verbrauchers liefern. Bspw. könnte man anhand einer derartigen Untersuchung eine Alterung von Bauteilen des elektrischen Verbrauchers oder einen mechanischen Verschleiß des elektrischen Verbrauchers oder eines von ihm angetriebenen Stellgliedes feststellen. Die Veränderung des Gesamtstroms beim Ein- und/oder Ausschalten eines Lastzweiges sollte einem bestimmten Signalverlaufsmuster folgen. Wenn es Abweichungen von diesem Muster gibt, so ist dies ebenfalls ein Anzeichen für eine Veränderung des elektrischen Verbrauchers.

So ist es bspw. von Vorteil, wenn die Analyseeinheit die Art der Veränderung des Stroms hinsichtlich des zeitlichen Verlaufs der Veränderung und/oder eine Veränderung der zeitlichen Korrelation eines Ansteuersignals zum Einschalten oder zum Ausschalten eines Schaltelements eines Lastzweiges mit der Detektion der Veränderung des Stroms infolge des Einschaltens und/oder des Ausschaltens des betreffenden Schaltelements analysiert. Die in diesem Zusammenhang durchführbaren Untersuchungen einer Vielzahl von die zeitliche Korrelation und/oder die Veränderung des Signalverlaufs des Stroms beschreibenden Parameter ist vielfältig und insbesondere applikationsabhängig. All diese Untersuchungen mit "Künstlicher Intelligenz" durchzuführen, macht es möglich, auch neuartige Veränderungen zu berücksichtigen.

In weiterer vorteilhafter Ausgestaltung der Erfindung kann die Analyseeinheit bspw. auch die mathematische Ableitung erster Ordnung und/oder zweiter Ordnung und/oder höherer Ordnung der Veränderung des Stroms und/oder das Integral über die Veränderung des Stroms und/oder die Größe und die Richtung der Veränderung des Stroms analysieren.

Besonders vorteilhaft ist es, wenn man die Analyse mittels der aktuell bekannten und auch noch zukünftig entwickelten Instrumente der "Künstlichen Intelligenz" durchführt. Bei einer insoweit vorteilhaften Ausführungsform der Erfindung weist die Analyseeinheit eine Datenverarbeitungseinheit auf, die auf der Grundlage einer Datenbank, in der Daten darüber abgelegt sind, welche den Betrieb des elektrischen Verbrauchers betreffende Ereignisse verschiedenen Ergebnissen der Analyse der Analyseeinheit jeweils zuzuordnen sind, nach Art von statistischen Modellen, insbesondere eines HMM-Modells oder eines künstlichen neuronalen Netzwerkmodells Ansteuersignale für die Schaltelemente der Lastzweige des elektrischen Verbrauchers oder für dessen Ansteuereinheit bildet und/oder signalisiert, wenn eine von der Analyseeinheit erstellte Analyse auf einen potenziellen oder tatsächlichen Fehler des elektrischen Verbrauchers hindeutet.

In weiterer vorteilhafter Ausgestaltung der Erfindung ist diese auf eine möglichst einfache und preisgünstige Ausgestaltung des Strommessmittels gerichtet. Wenn das Strommessmittel eine Messinduktivität aufweist bzw. zusätzlich zum Strommessmittel in Reihe zu diesem geschaltet eine Messinduktivität angeordnet wird, so kann der Detektor eine Veränderung des Stroms als über oder an oder infolge der Messinduktivität entstehenden Störpuls mit Berücksichtigung von dessen Polarität detektieren.

Gemäß dieser Variante der Erfindung dient also zur Lösung der oben genannten Aufgabe eine Vorrichtung zur Analyse von Strömen in einem elektrischen Verbraucher, der versehen ist, mit
- einer Parallelschaltung aus mehreren Lastzweigen,
- wobei jeder Lastzweig eine elektrische Last und ein diese wahlweise ein- oder ausschaltbares, steuerbares Schaltelement aufweist und
- einer Ansteuereinheit zur Erzeugung von Ansteuersignalen für die Schaltelemente,
wobei die Vorrichtung versehen ist mit
- einer in Reihe mit der Parallelschaltung der Lastzweige des Verbrauchers verbindbare Messinduktivität,
- einem Detektor zur Detektion der Größe und der Polarität eines beim Ein- oder Ausschalten eines Lastzweiges entstehenden Störpulses über der Messinduktivität und
- einer Analyseeinheit, die mit der Ansteuereinheit und dem Detektor verbunden ist und die zeitliche Korrelation eines Ansteuersignals zum Einschalten oder zum Ausschalten eines Schaltelements eines Lastzweiges mit der Detektion eines Störpulses über oder an oder infolge der Messinduktivität sowie dessen Polarität analysiert.

Bei der Erfindung wird eine komplexe Messimpedanz mit ohmschen-, zumeist parasitären und kapazitivem und/oder induktivem Anteil verwendet, die zwischen die Reihenschaltung aus den Lastzweigen des elektrischen Verbrauchers und entweder der Versorgungsspannung oder einem Bezugspotenzial (bspw. Masse) geschaltet ist. Typischerweise befindet sich in diesem Bereich ein Strommessmittel in Form insbesondere eines Shunt-Widerstandes.

Die erfindungsgemäß eingesetzte Messimpedanz weist bevorzugt eine Messinduktivität auf, die bewirkt, dass beim Einschalten eines der Lastzweige, ohne dass gleichzeitig ein anderer Lastzweig ausgeschaltet wird, an der Messinduktivität Störimpulse entstehen. Man würde also, wenn man den Spannungsabfall über der Messinduktivität erfassen würde, einen Spannungsabfallpuls erfassen. Denn da die Messimpedanz typischerweise einen parasitären ohmschen Widerstandsanteil umfasst, entsteht also ein entsprechender Spannungsabfall. Auch bei Verwendung eines kapazitiven Anteils der Messimpedanz entstehen beim Ein- und Ausschalten Störpulse.

Man kann nun analysieren, ob und wie die Störpulse an der Messinduktivität mit Einschalt- bzw. Ausschaltsignalen für die Schaltelemente der Lastzweige des elektrischen Verbrauchers zeitlich korrelieren. Dabei kann man bspw. in der Analyseeinheit der erfindungsgemäßen Vorrichtung dergestalt vorgehen, dass auf das Initiieren eines bspw. Einschaltsignals für ein Schaltelement ein Störpuls an der Messinduktivität folgt, und zwar innerhalb eines vorgegebenen Zeitfensters. Auch kann untersucht werden, ob die Polarität des Störpulses so ist, wie erwartet. Auf den Anwendungsfall der Messinduktivität bezogen ist der Störpuls beim Zuschalten eines Schaltelements positiv und beim Abschalten eines Schaltelements negativ.

Mit all diesen Untersuchungen kann dann festgestellt werden, ob der elektrische Verbraucher ordnungsgemäß oder fehlerhaft arbeitet. Im letztgenannten Fall könnte man dann, sofern gewünscht, eine Fehlermeldung ausgeben oder aber vorsichtshalber den Betrieb des elektrischen Verbrauchers gänzlich einstellen.

Alternativ ist es aber auch möglich, in Abhängigkeit von der Analyse der zeitlichen Korrelation von Ein- und Ausschaltsignalen für die Schaltelemente mit Störpulsen an der Messinduktivität zu bewerten, inwieweit die Ein- und Ausschaltsignale zeitlich verschoben werden müssen, um bspw. bestimmte Randbedingungen wie EMV-Emissionen einzuhalten. Aus Gründen der Reduktion derartiger EMV-Emissionen ist es bekannt, das Einschaltsignal für das Schaltelement eines Lastzweiges des elektrischen Verbrauchers zeitgleich mit dem Ausschaltsignal des Schaltelements eines anderen Lastzweiges zu erzeugen. In einem solchen Fall würde man also an der Messimpedanz idealerweise keine Störpulse detektieren können. Wenn dies aber dennoch erfolgen sollte, so ist das ein Anzeichen dafür, dass das Timing der zyklisch aufeinanderfolgenden Ein- und Ausschaltsignale für die Schaltelemente der einzelnen Lastzweige nicht optimal ist oder ein anderer Effekt vorliegt.

In weiterer zweckmäßiger Ausgestaltung der Erfindung kann also unter anderem auch vorgesehen sein, dass die Analyseeinheit analysiert, ob ein Störpulses hinsichtlich seines Betrags größer ist als ein vorgegebener Minimalpegel und/oder innerhalb eines Bereichs zwischen einem vorgegebenen Minimalpegel und einem vorgegebenen Maximalpegel liegt.

In weiterer zweckmäßiger Ausgestaltung der Erfindung kann ferner vorgesehen sein, dass der Detektor als ein Flankendetektor zur Detektion der ansteigenden oder der abfallenden Flanke eines Störpulses über der Messinduktivität mit jeweils einem vorgegebenen Minimalpegel ausgebildet ist.

Wie bereits oben erwähnt, verwendet man für die Messung der Ströme in den einzelnen Lastzweigen des elektrischen Verbrauchers mitunter ein gemeinsames Strommessmittel für sämtliche Lastzweige, das dann in Reihe mit der Parallelschaltung der Lastzweige angeordnet ist. Dieses Strommessmittel ist dann seinerseits in Reihe mit der Messinduktivität geschaltet.

Wie ebenfalls oben bereits kurz angedeutet, wird als Strommessmittel typischerweise ein Shunt-Widerstand eingesetzt, der als parasitäre Komponente eine Induktivität aufweist, wobei die parasitäre Induktivität des Shunt-Widerstandes die Messinduktivität bildet. In dieser Variante wird also als Messinduktivität des insoweit parasitären induktiv wirkenden Teil eines Shunt-Widerstands verwendet. Man könnte aber ebenso gut auch eine parasitäre kapazitive Komponente eines Strommessmittels verwenden, um Störpulse, die auf das Ein- und Ausschalten der Schaltelemente der Lastzweige des elektrischen Verbrauchers zurückzuführen sind, zu detektieren. Insoweit wird also in allgemeinster Form als Strommessmittel eine komplexe Impedanz eingesetzt, die neben einem ohmschen Anteil parasitäre, kapazitive und/oder induktive Komponenten aufweist.

In weiterer vorteilhafter Ausgestaltung der Erfindung kann vorgesehen sein, dass die Analyseeinheit analysiert, ob auf das Einschalten des Schaltelements eines der Lastzweige innerhalb eines vorgegebenen Zeitfensters ein Störpuls mit positiver Polarität und/oder auf das Ausschalten des Schaltelements eines der Lastzweige innerhalb eines vorgegebenen Zeitfensters ein Störpuls mit negativer Polarität folgt.

Die Analyseeinheit der erfindungsgemäßen Vorrichtung kann in einer weiteren vorteilhaften Ausprägung der Erfindung eine Diagnosekomponente aufweisen, die eine Fehlermeldung generiert, sofern auf das Einschalten des Schaltelements eines der Lastzweige innerhalb eines vorgegebenen Zeitfensters kein Störpuls mit positiver Polarität und/oder auf das Ausschalten des Schaltelements eines der Lastzweige innerhalb eines vorgegebenen Zeitfensters kein Störpuls mit negativer Polarität folgt.

Bei einem elektrischen Verbraucher, dessen Ansteuereinheit die Schaltelemente jeweils zweier aufeinanderfolgend wechselweise ein- und ausgeschalteter Lastzweige derart ansteuert, dass das Ausschalten des Schaltelements des einen Lastzweiges zeitgleich mit dem Einschalten des Schaltelements des anderen Lastzweiges erfolgt, kann die Auswerteeinheit gemäß einer vorteilhaften Variante der Erfindung analysieren, ob auf das Einschalten des Schaltelements des einen Lastzweiges innerhalb eines vorgegebenen Zeitfensters kein Störpuls mit positiver Polarität und/oder auf das Ausschalten des Schaltelements des anderen Lastzweiges innerhalb eines vorgegebenen Zeitfensters kein Störpuls mit negativer Polarität folgt.

In dem Fall, dass auf das Einschalten des Schaltelements eines der Lastzweige innerhalb eines vorgegebenen Zeitfensters ein Störpuls mit positiver Polarität und/oder auf das Ausschalten des Schaltelements eines der Lastzweige innerhalb eines vorgegebenen Zeitfensters ein Störpuls mit negativer Polarität folgt, steuert bei einer weiteren Ausgestaltung der Erfindung die Analyseeinheit die Schaltelement-Ansteuereinheit zur zeitlichen Verschiebung der Ansteuersignale zwecks zeitgleichen, wechselweisen Ein- und Ausschaltens sowie Aus- und Einschaltens der Schaltelemente der jeweils zwei Lastzweige des elektrischen Verbrauchers.

In einer weiteren Ausprägung der Erfindung kann das Einschalt-Ansteuersignal der Ansteuereinheit zum Einschalten des Schaltelements eines Lastzweiges eine ansteigende Schaltflanke aufweisen und das Ausschalt-Ansteuersignal der Ansteuereinheit für das Ausschalten des Schaltelements eines Lastzweiges eine abfallende Schaltflanke aufweisen.

Die Komponenten der erfindungsgemäßen Vorrichtung sind typischerweise in Form einer integrierten Schaltung und damit als ein IC ausgebildet. Ein derartiges IC kann dann in vorteilhafter Weise auch die Schaltelemente der Lastzweige des elektrischen Verbrauchers umfassen.

In weiterer vorteilhafter Ausgestaltung der Erfindung kann vorgesehen sein, dass die Analyseeinheit eine Datenverarbeitungseinheit aufweist, die auf der Grundlage einer Datenbasis, in der Daten darüber abgelegt sind, welches Ereignis verschiedenen Ergebnissen der Analyse der Analyseeinheit jeweils zuzuordnen ist, nach Art von statistischen Modellen, insbesondere eines HMM-Modells oder eines künstlichen neuronalen Netzwerkmodells Ansteuersignale für die Schaltelemente der Lastzweige des elektrischen Verbrauchers oder für dessen Ansteuereinheit bildet und/oder signalisiert, wenn eine von der Analyseeinheit erstellte Analyse auf einen potenziellen oder tatsächlichen Fehler des elektrischen Verbrauchers hindeutet. In dieser Ausprägung der Erfindung nutzt man also bspw. ein Instrument zur Daten-/Signal-Analyse und/oder Daten-/Signal-Verarbeitung, wie dies auch im Rahmen "Künstliche Intelligenz" erfolgt. Mit einer derartigen Datenverarbeitungseinheit setzt man wie bei der "Künstlichen Intelligenz" in bekannter Weise auf Datenanalysen anhand von vergleichsweise sehr großen Datenmengen auf, mit denen bspw. neuronale Netze in Trainings- und Lernphasen gespeist worden sind und die erlangt worden sind aus bspw. experimentellen Tests im Vorfeld des Einsatzes der Vorrichtung zur Analyse aktuell anstehender Analyse-Ergebnisse. Mit dem Begriff "Datenverarbeitungseinheit" sind somit im Rahmen der Erfindung sämtliche bekannte und zukünftige Instrumente der Daten-/Signal-Analysen und Daten-/Signal-Verarbeitung, mit denen das, was im engeren und weiteren Sinne unter "Künstliche Intelligenz" verstanden wird und/oder zukünftig noch verstanden werden wird, gemeint ist.

Schließlich schlägt die Erfindung zur Lösung der oben genannten Aufgabe auch noch vor einen elektrischen Verbraucher, mit
- einer Parallelschaltung aus mehreren Lastzweigen,
- wobei jeder Lastzweig eine elektrische Last und ein diese wahlweise ein- oder ausschaltbares, steuerbares Schaltelement aufweist und
- einer Ansteuereinheit zur Erzeugung von Ansteuersignalen für die Schaltelemente und
zusätzlich auch noch mit der Vorrichtung zur Analyse von Strömen in den Lastzweigen des elektrischen Verbrauchers gemäß einer der obigen Ausführungen.

Nachfolgend werden unter Bezugnahme auf die Zeichnung verschiedene Ausführungsbeispiele der Erfindung beschrieben. Im Einzelnen zeigen dabei:
- Fig. 1: schematisch die wesentlichen Elemente der Ansteuerung eines elektrischen Verbrauchers mit mehreren Lastzweigen, die parallel geschaltet sind und denen ein gemeinsames Strommessmittel zugeordnet ist,
- Fig. 2: ein erstes Ausführungsbeispiel einer erfindungsgemäßen Vorrichtung zur Analyse der Ströme in den Lastzweigen,
- Fig. 3: ein zweites Ausführungsbeispiel einer erfindungsgemäßen Vorrichtung zur Analyse der Ströme in den Lastzweigen,
- Fig. 4: ein weiteres Ausführungsbeispiel einer erfindungsgemäßen Vorrichtung zur Analyse der Ströme in den Lastzweigen,
- Fig. 5: schematisch den Aufbau eines kontaktlosen Strommessmittels, das als Alternative für die Shunt-Widerstände der Strommessmittel der Ausführungsbeispiele gemäß den Figuren 2 bis 4 verwendet werden kann,
- Fig. 6: ein alternatives Ausführungsbeispiel eines berührungslos arbeitenden Strommessmittels und
- Fig. 7: eine Schaltung für die Realisierung eines Flankendetektors, wie er für die Ermittlung der Störpulse an der Messinduktivität eingesetzt werden kann.

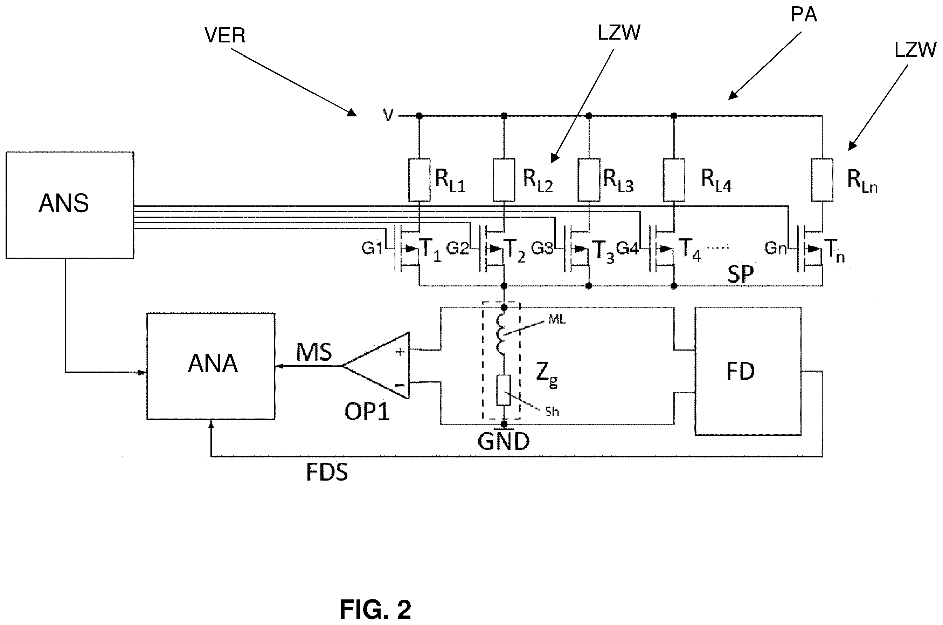

Fig. 2 zeigt ein erstes Ausführungsbeispiel einer erfindungsgemäßen Vorrichtung zur Analyse der jeweiligen Stromaufnahme eines mehrphasigen elektrischen Verbrauchers VER. Der Verbraucher VER weist eine Parallelschaltung PA aus mehreren Lastzweigen LZW auf, wobei jeder Lastzweig LZW eine elektrische Last RL1, RL2, RL3, RL4, ..., RLn und ein Schaltelement T1, T2, T3, T4, ... Tn aufweist. Mit dem Sternpunkt SP sämtlicher Lastzweige LZW ist ein Strommessmittel Z_{g} verbunden, das seinerseits mit dem Bezugspotenzial GND verbunden ist. Die Parallelschaltung PA ist mit der elektrischen Versorgung V verbunden.

Das Strommesssignal des Strommessmittels Z_{g} kann bspw. durch einen Verstärker OP1 als verstärktes Messsignal MS vorliegen, das eine Analyseeinheit ANA zugeführt wird. Zusätzlich existiert ein Detektor FD, der den Spannungsabfall über dem Strommessmittel Z_{g} bzw. den Strom detektiert und insbesondere auf Veränderungen des Stroms bzw. des Spannungsabfalls anspricht. Das vom Detektor FD gelieferte Detektorsignal FDS wird ebenfalls der Analyseeinheit ANA zugeführt.

Die Analyseeinheit ANA empfängt darüber hinaus von der Ansteuereinheit ANS für die Schaltelemente T1, T2, T3, T4, ... Tn ein Signal, das angibt, wann (ggf. welches) Schaltelement eingeschaltet oder ausgeschaltet wird.

In der Analyseeinheit ANA lassen sich nun diverse Untersuchungen durchführen, die der Analyse bzw. Diagnose des Verbrauchers VER dienen. Hier spielt bspw. die zeitliche Korrelation der Ansteuerung eines der Schaltelemente T1, T2, T3, T4, ... Tn mit dem Auftreten des Detektorsignals FDS eine Rolle. Des Weiteren kann auch die Form (Zeitverlauf) des Detektorsignals FDS in die Untersuchungen mit eingebracht werden. Sowohl die zeitliche Korrelation als auch der Detektionssignalverlauf sollte sich innerhalb jeweiliger Toleranzen bewegen, um bspw. den ordnungsgemäßen Betrieb des Verbrauchers VER oder aber auch einen Fehlerfall diagnostizieren zu können.

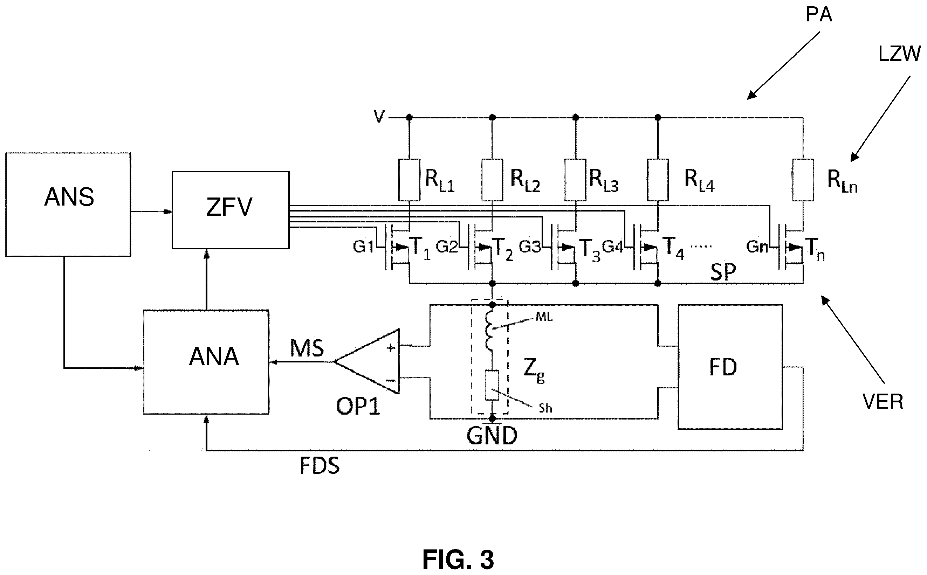

Die Vorrichtung nach Fig. 2 kann noch dahingehend erweitert werden, dass, wie in Fig. 3 gezeigt, durch die Analyse in der Analyseeinheit ANA Einfluss genommen wird auf die Zeitpunkte des Ein- und/oder Ausschaltens der einzelnen Schaltelemente. Dies kann fertigungstoleranzbedingt oder aufgrund von Alterungsprozessen des elektrischen Verbrauchers erforderlich sein. Auch unter dem Gesichtspunkt der Reduzierung von EMV-Emissionen kann eine zeitliche Verschiebung der Ein- und Ausschaltsignale für die einzelnen Schaltelemente von Vorteil sein. Hinsichtlich der Reduktion von EMV-Emissionen wird dergestalt verfahren, dass das Ausschaltsignal für das Schaltelement eines der Lastzweige LZW zeitgleich mit dem Einschaltsignal für das Schaltelement eines anderen Lastzweiges LZW zusammenfällt. Dann sollte der Detektor FD keinerlei Auffälligkeiten insbesondere im Wesentlichen keine Veränderungen des Stromverlaufs detektieren. Tut er es aber doch, ist dies ein Zeichen dafür, dass die zeitliche Übereinstimmung der zuvor genannten Ein- und Ausschaltsignale nicht gegeben ist. Durch die Vorrichtung ZFV zur zeitlichen Verschiebung dieser Signale lässt sich hier also eine Optimierung bzw. "Nachbesserung" einstellen. Die Vorrichtung ZFV zur zeitlichen Verschiebung erhält die Ansteuersignale von der Ansteuereinheit und verschiebt diese zeitlich relativ zueinander, und zwar in Abhängigkeit von dem von der Analyseeinheit ANA erhaltenen Signalen.

Weitere Ausgestaltungen der Erfindung werden nachfolgend unter weiterem Bezug auf zum Teil andere Figuren der Zeichnung beschrieben.

Die Erfindung geht in einer speziellen Ausgestaltung insbesondere zwei Aufgabenstellungen an, die sich häufig aus dem Stand der Technik ergeben.

Als erstes soll eine Untersuchung dahingehend durchgeführt werden können, ob die Schaltelemente T1 bis Tn bzw. die Transistoren sämtliche n Lastzweige der n Lasten RL1 bis RLn auch tatsächlich schalten. Eine solche Diagnose wird oft zu Sicherheitszwecken benötigt. Sie erlaubt die Detektion, ob eine Last z.B. ein Heizelement hochohmig ist oder ein Schaltelement nicht mehr schaltet. Ohne eine solche Detektion kann es zu Folgeschäden kommen, die leider infolge unzureichender Absicherung dieses Fehlerfalls Menschenleben kosten können.

Als zweites soll durch Analyse der Ein- und Ausschaltzeitpunkte der einzelnen Lastzweige eine Minimierung der Störabstrahlung durch den elektrischen Verbraucher im Betrieb erzielt werden. Das zeitversetzte Schalten der einzelnen Lasten sorgt zunächst im niederfrequenten Bereich, der typischerweise als Frequenzbereich mit Frequenzen von <1MHz interpretiert wird, für eine Verringerung der Störabstrahlung insbesondere der leitungsgebundenen Störungen. Der Verringerung von höherfrequente Störungen im Frequenzbereich >1MHz kann entgegenstehen, dass Produktionstoleranzen z.B. in der Schwellspannung der Schaltelemente T1 bis Tn aber auch in den Ansteuerzweigen in Form von leicht von der Idealform abweichenden Ansteuersignalen G1 bis Gn selbst dazu führen können, dass die einzelnen Lastzweige einerseits unterschiedliches Verhalten untereinander und andererseits auch unterschiedliches Verhalten für Einschalt- und Abschaltflanken zeigen.

Die n Schaltelemente T1 bis Tn, die Schaltsignalerzeugungseinheit CTR, das gemeinsame Strommessmittel Z_{g} für alle n Lastzweige, die Strommesselektronik z.B. mit einem Verstärker OP1 und typischerweise weitere Komponenten werden bevorzugt monolithisch in einer integrierten Schaltung IC integriert.

Ziel ist die Lösung dieser beiden Aufgaben mit möglichst wenigen diskreten Bauelementen außerhalb der integrierten Schaltung IC, um die System-Kostenposition zu verbessern.

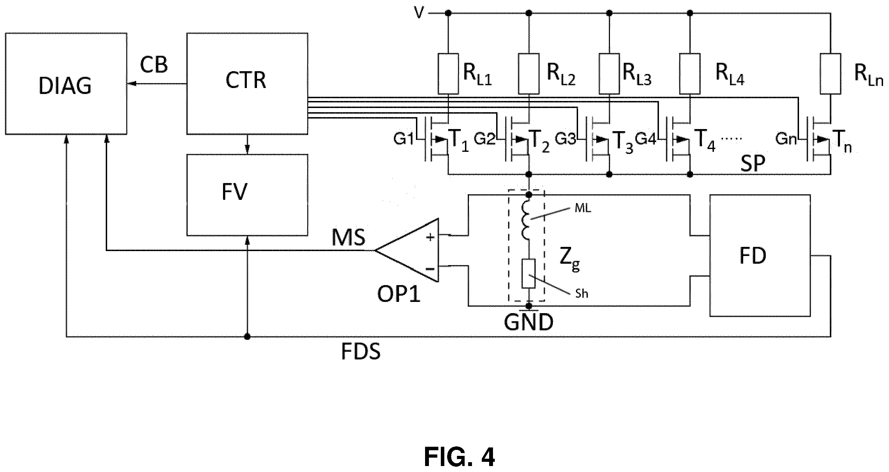

Beide oben genannten Aufgaben werden durch Verwendung einer Struktur nach Fig. 4 gelöst.

Dabei macht man sich die Tatsache zu Nutze, dass das gemeinsame Strommessmittel typischerweise eine parasitäre und damit meist unerwünschte Induktivität enthält. Diese ist in den Fign. 1 und 4 beispielhaft in Form einer Induktivität ML als Teil des Strommessmittels Z_{g} gezeigt. Bevorzugt handelt es sich bei dem Strommessmittel Z_{g} um einen ohmschen Widerstand, d.h. um einen sogenannten Shunt-Widerstand. Bei typischen Shunt-Widerständen Sh für die Nutzung als Strommessmittel Z_{g} liegt diese Induktivität ML meist bei einem Wert zwischen 5 nH und 10 nH.

Die parasitäre Induktivität ML des Strommessmittels Z_{g} sorgt in der Anwendungsschaltung für den unerwünschten Effekt, dass an jeder Schaltflanke eines der n Schaltelemente T1 bis Tn eine kurze, aber recht starke pulsartige Störung des Strommesssignals MS, das bevorzugt den Spannungsabfall über dem Strommessmittel Z_{g} wiedergibt, entsteht. Die Polarität dieser Störung hängt davon ab, ob sich während der Schaltflanke der Strom durch das Strommessmittel Z_{g} erhöht (d.h. die Störung ist ein positiver Strompuls) oder verringert (d.h. die Störung ist ein negativer Strompuls).

Die Erfindung führt über den Stand der Technik nach Fig. 1 hinaus einen Flankendetektor FD ein. Dieser Flankendetektor FD detektiert den Zeitpunkt des Auftretens der Störung an dem Strommessmittel Z_{g} und damit im Strommesssignal MS. In einer weiteren Ausführung kann der Flankendetektor FD auch die Polarität der Störung an dem Strommessmittel Z_{g} und damit im Strommesssignal MS detektieren. Beispielsweise kann die Polarität der Störung durch den Flankendetektor mit "keine Störung", "positive Störung" oder "negative Störung" bewertet werden. Ein Flankendetektor FD wird in jeglicher Ausführung der Erfindung benötigt. Dabei spielt es keine Rolle, ob die Erfindung zu Diagnosezwecken, zur Verringerung der Störabstrahlung oder zu beidem benutzt werden soll.

Der Flankendetektor FD kann sich direkt am Strommesselement Z_{g} befinden und beispielsweise den Spannungsabfall über dem Strommessmittel Z_{g} bewerten. Der Flankendetektor FD kann sich z.B. auch am Ausgang für das Strommesssignal MS befinden und dieses auswerten. Letzteres ist jedoch nur dann sinnvoll, wenn der Strommesspfad mit dem Verstärker OP1 und einem möglicherweise vorhandenen Tiefpass für das Strommesssignal MS sehr schnelle Reaktionszeiten von in der Regel <1µs hat und das Tiefpassfilter eben nicht vorhanden ist, was andere Regelungszwecke beeinträchtigt.

Die folgende Beschreibung von Ausführungsformen der Erfindung wird danach unterteilt, welchem der beiden oben beispielhaft genannten Zwecke die jeweilige Anwendung dienen soll. Aber es ist auch eine Anwendung möglich, bei der beide Zwecke kombiniert sind.

### DIAGNOSE

Zu diesem wird ein Diagnoseblock DIAG mit der Schaltsignalerzeugungseinheit CTR und dem Flankendetektor FD verbunden. Der Diagnoseblock DIAG enthält dabei folgende Funktionalität:
Die Schaltsignalerzeugungseinheit CTR erzeugt mittels der n Ansteuersignale G1 bis Gn Schaltereignisse für die n Schaltelemente T1 bis Tn. Die Schaltsignalerzeugungseinheit CTR signalisiert nun dem Diagnoseblock DIAG jedes dieser Schaltereignisse mittels z.B. eines Impulses oder z.B. eines wechselnden Signals. Der Diagnoseblock DIAG startet dann ein Aktivierungsintervall für eine bestimmte erste Zeitdauer. Detektiert der Flankendetektor FD innerhalb dieser ersten Zeitdauer einen Störpuls, so ist der Lastzweig auch tatsächlich geschaltet. Wurde durch die Schaltsignalerzeugungseinheit CTR nur ein einziges Schaltelement der im Zeitmultiplex angesteuerten n Schaltelemente T1 bis Tn geschaltet, so ist dieses Schaltelement und der zugehörige Lastzweig vorhanden und schaltet. Der Diagnoseblock DIAG kann daher diesen Lastzweig zumindest aus dieser funktionellen Sicht heraus als "in Ordnung" bewerten. Hat der Flankendetektor FD bis zum Ende der ersten Zeitdauer keine Flanke detektiert, so hat das Schaltelement des entsprechenden Lastzweigs nicht geschaltet oder der Lastzweig ist unterbrochen. Der Diagnoseblock DIAG bewertet daher typischerweise diesen Lastzweig zumindest aus dieser funktionellen Sicht heraus als "fehlerhaft", wobei der Diagnoseblock typischerweise nicht unterscheidet, ob der Fehler tatsächlich in dem Flankendetektor FD oder im betroffenen Lastzweig liegt, da dies für die sicherheitsrelevante Bewertung typischerweise nicht wichtig ist. Für viele Anwendungsfälle liegt diese erste Zeitdauer in einem Zeitdauerbereich von kleiner als 2 µs. Es gibt jedoch auch Ausnahmen bei speziellen Anwendungen (z.B. Glühkerzensteuerungen), bei denen die Schaltflanken deutlich träger sind und folglich auch die erste Zeitdauer deutlich erhöht sein kann. Die erste Zeitdauer kann in solchen Fällen z.B. 100 µs und mehr betragen.

Zu Plausibilitätstests bzw. zur weiteren Erhöhung der Aussagekraft kann in der Auswertung auch die Polarität des Schaltstörpulses berücksichtigt werden, wenn der Flankendetektor FD diese erfasst.

Auf ein Einschaltsignal der Schaltsignalerzeugungseinheit CTR für eines der n Schaltelemente T1 bis Tn muss dabei der Flankendetektor FD einen positiven Störpuls während der ersten Zeitdauer detektieren und an den Diagnoseblock DIAG z.B. mittels eines Flankendetektionssignals FDS übermitteln.

Auf ein Abschaltsignal für eines der n Schaltelemente T1 bis Tn muss dabei der Flankendetektor FD einen negativen Störpuls während der ersten Zeitdauer oder allgemein definiert einer vorgegebenen Zeitdauer detektieren und an den Diagnoseblock DIAG z.B. mittels des Flankendetektionssignals FDS übermitteln.

Somit ist es möglich, fehlerhafte Zustände sicher zu erkennen und ggf. eine Notabschaltung des Systems über einen Sicherheitsschalter, der in Serie zu der Versorgung V oder dem Bezugspotenzial GNG angeordnet sein kann, herbeizuführen.

### VERRINGERUNG DER STÖRABSTRAHLUNG (EME)

Zu diesem Zweck wird der Schaltsignalerzeugungseinheit CTR ein Schaltflankenverschiebungsblock FV zur zeitlichen Verschiebung der Schaltflanken, d.h. der Einschalt- und Ausschaltansteuersignale für die Schaltelemente, vor- oder nachgeschaltet.

Die folgende Beschreibung bezieht sich auf den Fall, dass der Flankenverschiebungsblock FV der Schaltsignalerzeugungseinheit CTR nachgeschaltet ist (siehe Fig. 4). Die Ausgänge der Analyseeinheit FV generieren dann zumindest einen Teil der n Ansteuersignale G1 bis Gn zum Steuern der entsprechenden Schaltelemente T1 bis Tn. Für die Anwendung werden hier zwei Möglichkeiten vorgestellt:

### 1) Messung und Kompensation der Verzögerungszeiten

Dabei misst der Flankenverschiebungslock FV bevorzugt für jeden einzelnen Lastzweig und bevorzugt jede steigende bzw. fallende Schaltflanke für das Schaltelement des jeweiligen Lastzweigs eine erste Verzögerungszeit zwischen dem Einschaltansteuersignal der Schaltsignalerzeugungseinheit CTR für das betreffende Schaltelement und dem Eintreffen des entsprechenden Störpulses am Strommessmittel Z_{g}, die der Flankendetektor FD detektiert. Der Flankenverschiebungsblock FV nutzt dann anschließend die gemessene erste Verzögerungszeit, um die Ansteuersignale G1 bis Gn so zueinander zu verschieben, dass eine steigende Schaltflanke für das Schaltelement eines Lastzweiges stets auf eine fallende Schaltflanke für das Schaltelement eines anderen Lastzweigs fällt und umgekehrt.

Bevorzugt kann der Flankenverschiebungsblock FV diese Verschiebung mittels eines statistischen Signalmodells, beispielsweise eines neuronalen Netzwerkmodells, bestimmen.

Der Flankenverschiebungsblock FV kann dabei einen Bewerter umfassen, der die Parameter eines solchen neuronalen Netzwerkmodells im Betrieb verbessert. Hierbei verstärkt der Bewerter die Parameter für solche Entscheidungen, die die jeweilige Lage, also beispielsweise die Störungen verbessern, also vermindern. Hierbei schwächt der Bewerter Parameter solcher Entscheidungen des neuronalen Netzwerkmodells, die die jeweilige Lage, also beispielsweise die Störungen verschlechtert haben, also vergrößern. Hierzu überprüft der Bewerter die Werte des Flankendetektorsignals FDS vor und nach der Änderung unter Zuhilfenahme des neuronalen Netzwerkmodells.

Um ein sicherheitsrelevantes fehlerhaftes Training zu vermeiden, ist es sinnvoll einen Sicherheitsbewerter vorzusehen, der offensichtlich fehlerhafte Verschiebungen durch den Flankenverschiebungsblock FV bzw. mit hoher Wahrscheinlichkeit in Zukunft fehlerhafte Verschiebungen des Flankenverschiebungsblock FV erkennt sowie unterbindet und das neuronale Netzwerkmodell entsprechend nachtrainiert. Beispielsweise können Verschiebungen über bestimmte Zeitwerte betragsmäßig hinaus unterbunden werden. Versucht der Flankenverschiebungsblock FV trotzdem, eine solche Verschiebung durchzuführen, ist das neuronale Netzwerkmodell fehlerhaft und der Sicherheitsbewerter hindert den Flankenverschiebungsblock FV an dieser zeitlichen Verschiebung aus dem zeitlichen Zielbereich hinaus und trainiert das neuronale Netzwerkmodell nach. Zum Training neuronalen Netzwerkmodelle sei auf die Literatur zu neuronalen Netzwerkmodellen aus dem Stand der Technik verwiesen.

Der Flankenverschiebungsblock FV nutzt, wie oben bereits beschrieben, anschließend die gemessene erste Verzögerungszeit, um die Ansteuersignale G1 bis Gn so gegeneinander zu verschieben, dass eine tatsächliche steigende Schaltflanke für das Schaltelement eines Lastzweigs stets auf eine fallende Schaltflanke eines anderen Lastzweigs fällt und umgekehrt. Dazu wird z.B. die größte gemessene erste Verzögerungszeit genutzt und die Schaltflanken um die größte gemessene erste Verzögerungszeit - zeitliche Verzögerung der entsprechenden Flanke des entsprechenden Lastzweigs - verschoben. Statt der größten gemessenen ersten Verzögerungszeit kann auch eine konstante Zeit genutzt werden, die garantiert mindestens der größten gemessenen ersten Verzögerung entspricht.

### 2) Minimierung der Dauer von Störungen

Solange eine Abschaltflanke eines Lastzweigs zeitlich nicht exakt auf eine Einschaltflanke eines anderen Lastzweigs trifft, beobachtet der Flankendetektor FD wenigstens zwei Flanken (Störpulse). Da die Schaltflanken selbst zeitlich nicht unendlich kurz sind, kann u.U. am Flankendetektor FD ein kurzzeitiges Störsignal entstehen, das mehr als nur zwei Flanken enthält.

Der Flankenverschiebungsblock FV misst eine zweite Zeitdauer der Störung und ändert die Verschiebung der Schaltflanken der Ansteuersignale G1 bis Gn mit dem Ziel, die zweite Zeitdauer der Störung entweder zu minimieren oder auf einen bestimmten Wert unterhalb eines ersten Schwellwerts betragsmäßig (im mathematischen Sinne gemeint) zu verringern.

Dabei ist die Richtung (vor- oder nacheilend), in die die Schaltflanken verschoben werden müssen, relativ einfach anhand der Polarität der vom Flankendetektor gemessenen Flanke der Störung zu ermitteln. Ist die erste aufgetretene Störflanke eine negative Flanke, so trat die Abschaltflanke für das Schaltelement, d.h. für das Schaltelement des einen Lastzweigs, zeitlich vor der Einschaltflanke für das andere Schaltelement auf. Der Flankenverschiebungsblock (FV muss die zeitliche Verzögerung der Abschaltflanke somit erhöhen oder die zeitliche Verzögerung der Einschaltflanke verringern. Ist die erste aufgetretene Flanke eine positive Flanke, so trat die Einschaltflanke vor der Abschaltflanke auf. Der Flankenverschiebungsblock FV muss in diesem umgekehrten Fall dann die zeitliche Verzögerung der Abschaltflanke ist somit verringern oder die zeitliche Verzögerung der Einschaltflanke erhöhen. Ist das Regelungsziel erreicht und sind Einschaltflanke und Abschaltflanke bezogen auf das Messergebnis des Flankendetektors FD z.B. exakt symmetrisch zueinander, so tritt der Fall ein, dass der Flankendetektor FD keine Flanke mehr detektiert. Dann besteht für den Flankenverschiebungsblock FV im Rahmen der Regelung keine Notwendigkeit einer Veränderung der zeitlichen Eingriffe mehr. Sobald z.B. durch Veränderungen der Umgebungsbedingungen das Regelungsziel nicht mehr erfüllt ist, detektiert der Flankendetektor FD wieder Störflanken und die Regelung durch den Flankenverschiebungsblock FV kann weiterarbeiten.

### KOMBINATION AUS DIAGNOSE UND STÖRABSTRAHLVERRINGERUNG

Zu diesem dritten Zweck kann die Analyseeinheit sowohl die Flankenverschiebung als auch die Diagnosefunktionalität aufweisen (Fig. 4) und deren Funktionen miteinander kombiniert werden.

Beim Diagnosezweck können entsprechende Verfeinerungen vorgenommen werden. Löschen sich steigende und fallende Flanke aus und detektiert der Flankendetektor FD somit keine Flanke mehr, so kann der Diagnoseblock DIAG davon ausgehen, dass entweder beide Flanken auftraten und beide betreffenden Lastzweige in Ordnung sind.

Sind jedoch beide Lastzweige defekt, so würde bei mehr als zwei Lastzweigen an einer anderen zeitlichen Stelle eine Störflanke detektiert werden, für die der Flankenverschiebungsblock FV keine Korrektur mehr durchzuführen kann. Es ist daher sinnvoll, wenn der Diagnoseblock DIAG die erfolgreiche zeitliche Flankenverschiebung des Flankenverschiebungsblocks FV in einer nachfolgenden Periode ermittelt und bewertet. Hierzu teilt der Flankenverschiebungsblock FV dem Diagnoseblock DIAG bevorzugt eine entsprechende Information über eine solche Flankenverschiebung mit. Alternativ kann diese Diagnose natürlich auch der Flankenverschiebungsblock FV selbst ausführen.

Bei nicht idealer Auslöschung der Flanken ist anhand der Störung selbst stets beobachtbar, ob beide betroffenen Lastzweige auch tatsächlich geschaltet wurden. Hierzu muss die durch den Flankendetektor FD detektierte Störung mindestens eine steigende und eine fallende Störflanke (positiver und negativer Störpulse) enthalten.

### Ausführungen des Strommessmittels

Die hier aufgeführten Ausführungen des Strommessmittels dienen als Beispiele, erheben aber keinesfalls einen Anspruch auf Vollständigkeit. Sie stellen den Stand der Technik dar und beschreiben dessen geeignete Nutzung im Rahmen dieser Erfindung. Eine mögliche Erweiterung ist ebenfalls angegeben.

### 1) Shunt-Widerstand

Die Verwendung eines Shunt-Widerstands ist in der Regel die preisgünstigste Variante zur Strommessung. Sie ist in der Fig. 1 dargestellt. Der Shunt-Widerstand bringt eine parasitäre Induktivität mit sich. Die Ausnutzung dieser Induktivität als Messinduktivität ML ist bereits weiter oben beschrieben.

### 2) Kontaktlose Strommessung

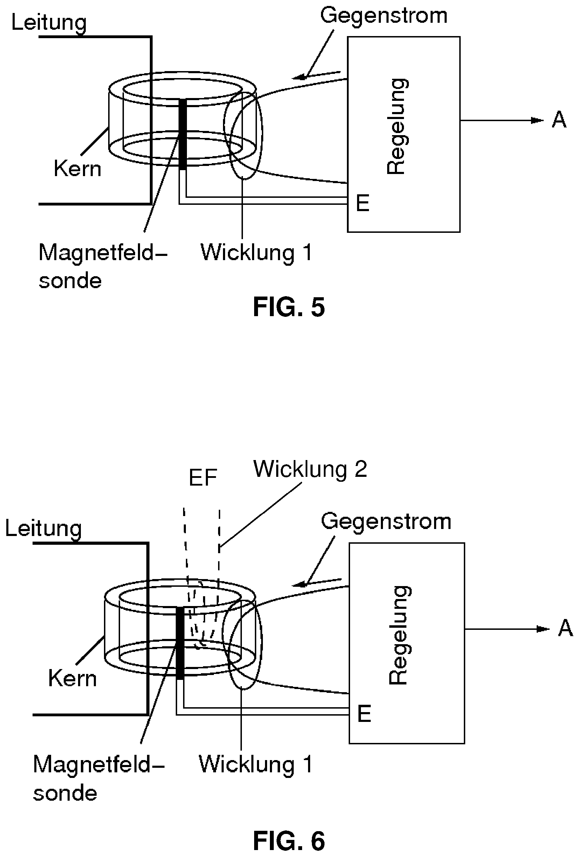

Fig. 5 zeigt einen kontaktlosen Stromsensor nach dem Stand der Technik. Die Leitung, deren Strom zu messen ist, wird durch einen Kern, beispielsweise einen Ferritkern, geführt. Der Kern dient zur Bündelung der magnetischen Flussdichte B. Der Kern ist nicht zwingend erforderlich, in der Regel aber vorteilhaft. Das Verfahren funktioniert auch ohne Kern. Jedoch hat man mit Kern Vorteile bezüglich der Empfindlichkeit der Messung.

Im Kern (z.B. in einem Spalt des Kerns) befindet sich eine Messsonde zur Messung der magnetischen Feldstärke H oder Flussdichte B. Meist ist dies ein Hallelement. Eine erste Wicklung 1 ist auf dem Kern angeordnet, um ein Gegenfeld zu demjenigen Magnetfeld zu erzeugen, das durch die zu vermessende stromführende Leitung erzeugt wird. Eine Regelung misst am Eingang E das Ausgangssignal der Magnetfeldsonde und erzeugt einen Gegenstrom in der ersten Wicklung 1 mit dem Ziel, die magnetische Feldstärke H bzw. die magnetische Flussdichte B im Kern auf den Wert Null zu regeln. Der Wert des Gegenstroms ist dann ein Maß für den in der Leitung fließenden elektrischen Strom. Der Wert des Gegenstroms wird an einem weiteren Ausgang A entweder als Strom oder umgewandelt in eine Spannung zur vorzugsweise mit einem Proportionalitätsfaktor multipliziert, zur Verfügung gestellt. Ausgang A liefert somit das Strommesssignal MS.

Eine solche Baugruppe ist meist wegen der Trägheit der Regelung nicht geeignet, um am Ausgang A eine Detektion der Flanken zu erlauben, wie dies zur Anwendung bei dieser Erfindung nötig ist. Jedoch trägt sie durch ihren Aufbau dazu bei, die Induktivität der durch den Kern geführten Leitung deutlich zu erhöhen.

Das Signal, anhand dessen die Flanken detektiert werden sollen, kann also problemlos an den Anschlüssen der Leitung selbst abgegriffen werden, allerdings mit der Konsequenz, dass die Flankendetektion dann wieder galvanisch mit der Leitung verbunden ist.

Besteht jedoch die Anforderung, dass die Flankendetektion selbst galvanisch getrennt vom Strompfad aufzuführen ist, so kann entweder die Spannung an der ersten Wicklung 1 direkt als Messsignal für den Flankendetektor FD abgegriffen (die Regelung beeinflusst nur den Strom und ist von der Spannung unabhängig) oder die in Fig. 6 gezeigte Erweiterung vorgenommen werden. Dazu wird eine weitere Wicklung 2 auf den Kern gebracht, deren Anschlüsse direkt zum Flankendetektor FD führen.

Selbstverständlich kann die weitere Wicklung 2 auch auf einen weiteren Kern gebracht werden, der unabhängig von der Strommesseinrichtung ist und durch den die (Mess-)Leitung gelegt wird. Die weitere Wicklung 2 kann auch als Luftspule ausgeführt sein und in geeigneter Lage zur Messleitung liegen. Sie kann beispielsweise Teil einer Leiterbahn einer gedruckten Schaltung sein.

### Flankendetektor

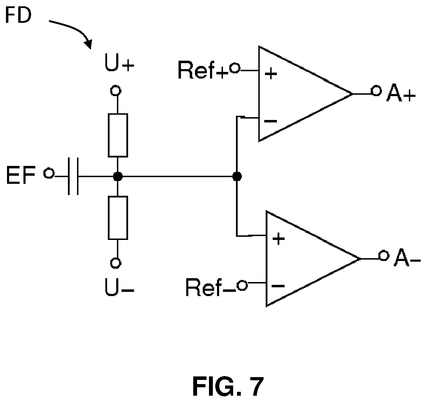

Der Flankendetektor FD kann nach dem Stand der Technik relativ einfach z.B. mit einem Hochpass und Komparatoren CMP1, CMP2 ausgeführt werden. Fig. 7 zeigt einen solchen einfachen Flankendetektor FD. Der Hochpass wird durch die Kapazität C und den Widerstandsteiler R1, R2 gebildet. Der Widerstandsteiler R1, R2 legt gleichzeitig die Ruhelage des Eingangssignals DEF für die beiden Komparatoren CMP1, CMP2 fest. Deren Referenzsignale Ref+, Ref- liegen auf jeweils geeigneten Werten oberhalb und unterhalb der Ruhelage. Bei einer steigenden Flanke am Eingang EF des Flankendetektors FD wird dann kurzzeitig das Ausgangssignal A+ für die steigende Flanke aktiv. Bei einer negativen Flanke am Eingang EF des Flankendetektors FD wird kurzzeitig das Ausgangssignal A-für die fallende Flanke aktiv. Bevorzugt ist der Diagnoseblock DIAG mit dem Ausgangssignal A- für die fallende Flanke und dem Ausgangssignal A+ für die steigende Flanke verbunden. Das Ausgangssignal A- für die fallende Flanke und das Ausgangssignal A+ für die steigende Flanke bilden zusammen in diesem Beispiel das Flankendetektorsignal FDS.

Soll der Flankendetektor FD rein für Diagnosezwecke genutzt werden und nicht zur EME-Optimierung (Optimierung des Abstrahlverhaltens), so reicht unter Umständen einer der beiden Komparatoren CMP1, CMP2 aus und es wird dann nur eine der beiden Schaltflanken im Diagnoseblock DIAG behandelt.

### Merkmale der Erfindung und/oder von deren Varianten

Auch wenn im Folgenden verschiedene Versionen aufgeführt werden, gemäß der die Erfindung ausgeführt sein kann, können bei Bedarf einzelne Merkmale verschiedener Versionen miteinander kombiniert werden.

### VERSION 1

Die Erfindung gemäß dieser ersten Version betrifft eine Vorrichtung zum geschalteten Ansteuern von mehreren Lasten RL1 bis RLn, mit Schaltelementen T1 bis Tn, einer Schaltsignalerzeugungseinheit CTR, einem gemeinsamen Strommesselement Z_{g}, einem einen Flankendetektor FD, einem Sternpunkt SP einem Flankendetektorsignal FDS und mit Ansteuersignalen G1 bis Gn. Die Schaltelemente T1 bis Tn sind dabei dazu eingerichtet und vorgesehen, jeweils eine oder mehrere Lasten RL1 bis RLn mit einer Versorgung V und/oder dem Sternpunkt SP zu verbinden und von diesen zu trennen. Das Strommesselement Z_{g} ist zwischen den Sternpunkt SP und das Bezugspotenzial GND geschaltet. Die Schaltsignalerzeugungseinheit CTR steuert die Schaltelemente T1 bis Tn mit den Ansteuersignalen G1 bis Gn. Das Strommesselement Z_{g} erfasst den Strom zwischen Sternpunkt SP und Bezugspotenzial GND und erzeugt ein Strommesswertsignal. Der Flankendetektor FD wertet das Strommesswertsignal aus und erfasst ggf. das Vorliegen einer Flanke. Er signalisiert mittels des Flankendetektorsignals FDS das Vorliegen einer Flanke auf dem Strommesswertsignal. Das Flankendetektorsignal FDS kann die Schaltzeitpunkte der Schaltelemente T1 bis Tn beeinflussen. Das Flankendetektorsignal FDS kann ggf. auch parallel oder alternativ zur Fehlerzustandsdetektion verwendet werden.

In einer ersten Ausgestaltung weist die Vorrichtung eine erste Zeitmessvorrichtung auf. Die erste Zeitmesseinrichtung misst eine erste Zeitdauer von der Zustandsänderung zumindest eines erzeugten Ansteuersignals zu einem ersten Zeitpunkt bis zum Beginn einer Signalisierung mittels des Flankendetektorsignals FDS und erzeugt bevorzugt einen Messwert für diese erste Zeitdauer.

In einer zweiten Ausgestaltung umfasst das Flankendetektorsignal FDS die Information über Richtung einer erfassten Flanke zumindest zweitweise mit.

In einer dritten Ausgestaltung weist die Vorrichtung eine zweite Zeitmessvorrichtung auf, die mit der ersten Zeitmessvorrichtung identisch oder gleich sein kann. Die zweite Zeitmessvorrichtung misst die zweite Zeitdauer des Vorliegens eines am Flankendetektor FD gemessenen Störsignals. Ein Störsignal ist im Sinne dieser Offenlegung eine Folge von steigenden und fallenden Flanken, die innerhalb eines ersten vorgegebenen Zeitintervalls liegen.

In einer vierten Ausgestaltung weist die Vorrichtung einen Zeitfenstergenerator auf. Der Zeitfenstergenerator erzeugt mit dem Auftreten eines bestimmten Schaltsignalereignisses in der Schaltsignalerzeugungseinheit CTR oder mit einer bestimmten Verzögerung zu diesem Schaltsignalereignis ein zweites vorgegebenes Zeitintervall. Typischerweise handelt es sich dabei um ein Signal, dass für dieses Zeitintervall einen speziellen Zustand einnimmt.

In einer fünften Ausgestaltung weist die Vorrichtung eine dritte Zeitmessvorrichtung auf, die mit der ersten und/oder zweiten Zeitmessvorrichtung identisch sein kann. Das Strommesselement weist in dieser Verfeinerung einen zusätzlichen Ausgang auf, der den Strom durch das Strommesselement widerspiegelt. Der Flankendetektor FD wertet das Signal dieses zusätzlichen Ausgangs aus. Die dritte Zeitmessvorrichtung misst die dritte Zeitdauer vom Beginn von der Zustandsänderung zumindest eines erzeugten Ansteuersignals bis zum Beginn der am Flankendetektor FD detektierten Flanke und erzeugt einen zugehörigen Messwert.

In einer sechsten Ausgestaltung wird für die Messung der dritten Zeitdauer die erfasste Richtung der Flanke mitberücksichtigt. Es werden also nicht immer alle Flanken in dieser Verfeinerung verwendet.

In einer siebten Ausgestaltung weist die Vorrichtung eine vierte Zeitmessvorrichtung auf, die mit der ersten Zeitmessvorrichtung und/oder der zweiten Zeitmessvorrichtung und/oder der dritten Zeitmessvorrichtung identisch oder gleich sein kann. Das Strommesselement weist in dieser Verfeinerung wieder einen zusätzlichen Ausgang auf, der den Strom durch das Strommesselement widerspiegelt. Der Flankendetektor FD wertet das Signal dieses zusätzlichen Ausgangs aus. Die vierte Zeitmessvorrichtung misst die zweite Zeitdauer des Vorliegens eines am Flankendetektor FD gemessenen Störsignals und erzeugt einen entsprechenden Messwert. Als ein Störsignal gilt hierbei eine Folge von steigenden und fallenden Flanken, die innerhalb eines ersten oder anderen vorgegebenen Zeitintervalls liegt.

In einer achten Ausgestaltung weist die Vorrichtung eine fünfte Zeitmessvorrichtung, auf, die mit der ersten Zeitmessvorrichtung und/oder der zweiten Zeitmessvorrichtung und/oder der dritten Zeitmessvorrichtung und/oder der vierten Zeitmessvorrichtung identisch oder gleich sein kann. Das Strommessmittel umfasst bevorzugt eine Teilvorrichtung und/oder Teilvorrichtungen, insbesondere eine Induktivität oder Gegeninduktivität. Diese Teilvorrichtung des Stromessmittels Z_{g} ist bevorzugt dazu geeignet und/oder vorgesehen, eine Stromänderung in einer Leitung zwischen Sternpunkt SP und Bezugspotenzial GND in ein zur Flankendetektion durch den Flankendetektor FD geeignetes Signal zu überführen. Die fünfte Zeitmessvorrichtung misst die fünfte Zeitdauer vom Beginn von der Zustandsänderung zumindest eines erzeugten Ansteuersignals bis zum Beginn der am Flankendetektor FD detektierten Flanke und erzeugt einen entsprechenden Messwert.

In einer neunten Ausgestaltung wird für die Messung wird für die Messung der fünften Zeitdauer durch die fünfte Zeitmessvorrichtung die Richtung der Flanke mitberücksichtigt. Es werden also nicht immer alle Flanken in dieser Verfeinerung verwendet.

In einer zehnten Ausgestaltung weist die Vorrichtung eine sechste Zeitmessvorrichtung auf, die mit der ersten Zeitmessvorrichtung und/oder der zweiten Zeitmessvorrichtung und/oder der dritten Zeitmessvorrichtung und/oder der vierten Zeitmessvorrichtung und/oder der fünften Zeitmessvorrichtung identisch oder gleich sein kann. Das Strommessmittel umfasst wieder eine Teilvorrichtung und/oder Teilvorrichtungen, insbesondere eine Induktivität oder Gegeninduktivität. Diese Teilvorrichtung des Stromessmittels Z_{g} ist bevorzugt dazu geeignet und/oder vorgesehen, eine Stromänderung in der Leitung zwischen Sternpunkt SP und Bezugspotenzial GND in ein zur Flankendetektion durch den Flankendetektor FD geeignetes Signal zu überführen. Die sechste Zeitmessvorrichtung misst die sechste Zeitdauer des Vorliegens eines am Flankendetektor FD gemessenen Störsignals und erzeugt einen entsprechenden Messwert. Ein Störsignal in diesem Sinne ist wieder eine Folge von steigenden und fallenden Flanken ist, die innerhalb eines ersten oder anderen vorgegebenen Zeitintervalls.

In einer elften Ausgestaltung weist die Vorrichtung einen Zeitfenstergenerator auf. Das Strommessmittel umfasst wieder eine Teilvorrichtung und/oder Teilvorrichtungen, insbesondere eine Induktivität oder Gegeninduktivität. Diese Teilvorrichtung des Stromessmittels Z_{g} sind bevorzugt dazu geeignet und/oder vorgesehen, eine Stromänderung in der Leitung zwischen Sternpunkt SP und Bezugspotenzial GND in ein zur Flankendetektion durch den Flankendetektor FD geeignetes Signal zu überführen. Der Zeitfenstergenerator erzeugt mit dem Auftreten eines bestimmten Schaltsignalereignisses in der Schaltsignalerzeugungseinheit CTR oder mit einer bestimmten Verzögerung zu diesem Schaltsignalereignis ein drittes vorgegebenes Zeitintervall.

In einer zwölften Ausgestaltung weist die Vorrichtung eine Analyseeinheit FV auf. Die Analyseeinheit FV ist dazu geeignet und/oder vorgesehen, abhängig von zumindest einer der oben erwähnten gemessenen Zeitdauern die Ansteuersignale G1 bis Gn oder deren Erzeugung so zu verzögern oder zeitlich zu verschieben, dass der Flankendetektor FD keine Flanken mehr detektiert.

In einer dreizehnten Ausgestaltung weist die Vorrichtung eine Analyseeinheit FV auf, wobei die Analyseeinheit FV dazu geeignet und/oder vorgesehen ist, abhängig von zumindest einer der oben erwähnten gemessenen Zeitdauern die Ansteuersignale G1 bis Gn oder deren Erzeugung so zu verzögern oder zeitlich zu verschieben, dass die betreffende Zeitdauer minimiert wird oder betragsmäßig einen vorgegebenen zeitlichen Wert nicht überschreitet.

In einer vierzehnten Ausgestaltung weist die Vorrichtung eine Analyseeinheit FV auf, wobei die Analyseeinheit FV nun dazu geeignet und/oder vorgesehen ist, abhängig davon, ob die erste, durch den Flankendetektor FD in einem Zeitintervall erfasste Flanke eine positive oder negative Flanke ist, die Einschaltflanke oder Abschaltflanke eines Ansteuersignals G1 bis Gn und/oder ein anderer Zustandswechsel eines Ansteuersignals G1 bis Gn zeitlich verzögert oder zeitlich vorgezogen wird.

In einer fünfzehnten Ausgestaltung weist die Vorrichtung einen Diagnoseblock DIAG auf, wobei der Diagnoseblock DIAG ein Fehlersignal erzeugt oder bereitstellt, wenn der Flankendetektor FD nicht innerhalb eines vorgegebenen Zeitfensters zeitlich bezogen nach einem Zustandswechsel eines Ansteuersignals G1 bis Gn eine Flanke detektiert.

In einer sechzehnten Ausgestaltung weist die Vorrichtung einem Diagnoseblock DIAG auf, wobei der Diagnoseblock DIAG kein Fehlersignal erzeugt oder bereitstellt, wenn der Flankendetektor FD innerhalb eines vorgegebenen Zeitfensters zeitlich bezogen nach einem Zustandswechsel eines Ansteuersignals G1 bis Gn kein Paar zweiter zeitlich aufeinanderfolgender Flanken detektiert.

In einer weiteren siebzehnten Ausgestaltung werden die Zeitfenster von Signalpaaren zyklisch getauscht, um Mehrfachfehler zu identifizieren.

In einer achtzehnten Ausgestaltung weist die Vorrichtung eine Analyseeinheit FV auf, wobei die Analyseeinheit FV dazu geeignet und/oder vorgesehen ist, die Einschaltflanke oder Abschaltflanke eines Ansteuersignals G1 bis Gn und/oder ein anderer Zustandswechsel eines Ansteuersignals G1 bis Gn zeitlich verzögert oder zeitlich vorgezogen wird. Nun umfasst die Analyseeinheit FV ein neuronales Netzwerkmodell oder eine andere Struktur, die ein Modell der Künstlichen Intelligenz ist und insbesondere ein Deep-Learning und/oder ein Machine-Learning Verfahren durchführen kann. Gemäß den Grundsätzen der vorliegenden Offenlegung umfasst die Vorrichtung in dieser Variante das besagte neuronale Netzwerkmodell, das bevorzugt als Softwaremodel in einem digitalen Speicher beispielsweise der Analyseeinheit FV gespeichert ist und von einem Rechner, der bevorzugter Teil der Vorrichtung ist ausgeführt wird. Neuronale Netzwerkmodelle mit Deep Learning umfassen Software, die von einem Software-Designer geschrieben werden kann und auch aus einer Reihe von Quellen öffentlich verfügbar ist. Eine Anwendung, die zum Erstellen eines neuronalen Netzmodells mit dem Namen "NVidia Digits" verwendet werden kann, ist unter https://developer.nvidia.com/digits verfügbar. Bei NVidia Digits handelt es sich um eine Benutzeroberfläche auf hohem Niveau, die ein Deep Learning-Framework namens "Caffe" umfasst, das vom Berkley Vision and Learning Center (http://caffe.berkeleyvision.org/) entwickelt wurde. Eine Liste gängiger Deep-Learning-Frameworks, die zur Verwendung in einer Implementierung der vorliegenden Erfindung geeignet sind, findet man unter https://developer.nvidia.com/deep-learning-frameworks.

In einer neunzehnten Ausgestaltung weist die Vorrichtung einen Diagnoseblock DIAG auf, wobei der Diagnoseblock DIAG ein neuronales Netzwerkmodell umfasst. Das zuvor zu neuronalen Netzen, Rechnern, Speichern, Deep-Learning. Machine-Learning und den Trainingsmethoden gesagte trifft hier auch zu.

In einer zwanzigsten Ausgestaltung ist das Eingangssignal des Flankendetektors FD von dem Sternpunkt SP galvanisch getrennt.

### VERSION 2

Gemäß dieser zweiten Version betrifft die Erfindung eine Vorrichtung zum geschalteten Ansteuern von mehreren Lasten RL1 bis RLn mit Schaltelementen T1 bis Tn, einer Schaltsignalerzeugungseinheit CTR, Ansteuersignalen G1 bis Gn, einer Messvorrichtung und einer Analyseeinheit FV. Die Schaltelemente T1 bis Tn sind dazu eingerichtet und vorgesehen, jeweils eine oder mehrere Lasten RL1 bis RLn mit einer Versorgung V und/oder einem Sternpunkt SP bzw. einem Bezugspotenzial GND zu verbinden und von diesen zu trennen. Die Schaltsignalerzeugungseinheit CTR steuert die Schaltelemente T1 bis Tn mit den Ansteuersignalen G1 bis Gn. Die Messvorrichtung erfasst relevante Betriebszustandsdaten der Vorrichtung. Die Analyseeinheit FV ist dazu geeignet und/oder vorgesehen, die Einschaltflanke oder Abschaltflanke eines Ansteuersignals G1 bis Gn und/oder ein anderer Zustandswechsel eines Ansteuersignals G1 bis Gn zeitlich zu verzögern oder zeitlich vorzuziehen. Die Analyseeinheit FV umfasst ein neuronales Netzwerkmodell. Die Analyseeinheit FV verwendet erfasste Betriebszustandsdaten als Eingabe für das neuronale Netzwerkmodell.

Bei einer ersten Variante dieser zweiten Version umfasst die Vorrichtung einen Bewertungsblock, der die Parameter eines solchen neuronalen Netzwerkmodells im Betrieb überprüft und/oder verändert.

Bei einer zweiten Variante dieser zweiten Version umfasst die Vorrichtung einen Sicherheitsbewertungsblock, der offensichtlich fehlerhafte und ggf. sicherheitsrelevante Änderungen der Kommutierung vor deren Durchführung erkennt und verhindert.

Bei einer dritten Variante dieser zweiten Version verändert der Sicherheitsbewertungsblock die Parameter eines solchen neuronalen Netzwerkmodells im Betrieb im Falle einer versuchten, offensichtlich fehlerhaften und ggf. sicherheitsrelevanten Änderung der Kommutierung durch das neuronale Netzwerkmodell.

### VERSION 3

Gemäß dieser dritten Version betrifft die Erfindung eine Vorrichtung zum geschalteten Ansteuern von mehreren Lasten RL1 bis RLn mit Schaltelementen T1 bis Tn, einer Schaltsignalerzeugungseinheit CTR, Ansteuersignalen G1 bis Gn, einer Messvorrichtung und mit einer Analyseeinheit FV. Die Schaltelemente T1 bis Tn sind dazu eingerichtet und vorgesehen, jeweils eine oder mehrere Lasten RL1 bis RLn mit einer Versorgung V und/oder einem Sternpunkt SP bzw. einem Bezugspotenzial GND zu verbinden und von diesen zu trennen. Die Schaltsignalerzeugungseinheit CTR steuert die Schaltelemente T1 bis Tn mit den Ansteuersignalen G1 bis Gn. Die Messvorrichtung erfasst Betriebszustandsdaten der Vorrichtung. Die Analyseeinheit FV ist dazu geeignet und/oder vorgesehen, die Einschaltflanke oder Abschaltflanke eines Ansteuersignals G1 bis Gn und/oder ein anderer Zustandswechsel eines Ansteuersignals G1 bis Gn zeitlich zu verzögern oder zeitlich vorzuziehen. Die Analyseeinheit FV umfasst ein statistisches Modell zur Berechnung zeitlicher Abfolgemuster und/oder zur Prädiktion zeitlicher Abfolgen. Hierbei kann es sich beispielsweise um ein Viterbi- oder HMM-Modell handeln. Die Analyseeinheit FV verwendet erfasste Betriebszustandsdaten als Eingabe für das statistische Modell.

In einer ersten Ausgestaltung dieser dritten Version handelt es sich bei dem statistischen Modell um ein HMM Modell oder ein neuronales Netzwerkmodell.

In einer zweiten Ausgestaltung dieser dritten Version umfasst die Vorrichtung einen Bewertungsblock, der die Parameter eines solchen statistischen Modells im Betrieb überprüft und/oder verändert.

In einer dritten Ausgestaltung dieser dritten Version umfasst die Vorrichtung einen Sicherheitsbewertungsblock, der - offensichtlich fehlerhafte und ggf. sicherheitsrelevante Änderungen der Kommutierung vor deren Durchführung erkennt und verhindert.

In einer vierten Ausgestaltung dieser dritten Version verändert der Sicherheitsbewertungsblock die Parameter eines solchen statistischen Modell im Betrieb im Falle einer versuchten, offensichtlich fehlerhaften und ggf. sicherheitsrelevanten Änderung der Kommutierung durch das statistischen Modell.

Ein bevorzugtes Detail der hier vorgestellten Vorrichtungen betrifft die Messvorrichtung für die Messung des Summenstromes. Die Messvorrichtung weist einen Leiter, eine erste Wicklung 1, eine zweite Wicklung 2, eine Regelung und eine Magnetfeldsonde auf. Der Leiter und die erste Wicklung 1 und die zweite Wicklung 2 stehen in einem magnetischen Wirkzusammenhang zueinander. Insbesondere kann bei Veränderungen der magnetischen Flussdichte durch einen von diesen eine Induktion in den anderen stattfinden. Der Leiter ist dazu vorgesehen und/oder bestimmt ist, zwischen den Sternpunkt SP und dem Bezugspotenzial GND als gemeinsames Messmittel Z_{g} geschaltet zu werden, so dass der Summenstrom durch diesen vom Sternpunkt zum Bezugspotenzial GND fließen kann. Die Magnetfeldsonde das Magnetfeld des den Leiter durchfließenden Stroms und das der Wicklungen als Magnetfeldmesswert erfasst. Der Regler erzeugt mit Hilfe des Magnetfeldmesswerts einen geregelten Gegenstrom, der die erste Wicklung 1 durchfließt und der mittels der ersten Wicklung 1 das magnetische Feld des Leiters mit einer ersten Zeitkonstante kompensiert. Die weitere zweite Wicklung 2 ist dazu bestimmt und vorgesehen, als Strommesselement Z_{g} für den Flankendetektor FD mit einer zweiten Zeitkonstante genutzt zu werden. Die zweite Zeitkonstante ist bevorzugt kleiner als die erste Zeitkonstante.

### VERSION 4

Gemäß dieser vierten Version betrifft die Erfindung eine Vorrichtung zum geschalteten Ansteuern von mehreren Lasten RL1 bis RLn mit einer Teilvorrichtung zum Ansteuern dieser Lasten. Die Teilvorrichtung umfasst dabei ein statistisches Modell.

In einer ersten Variante dieser vierten Version handelt es sich bei dem statistischen Modell um ein HMM Modell oder ein neuronales Netzwerkmodell oder ein HMM-Modell oder ein Petri-Netz.

### VERSION 5

Die fünfte Version betrifft ein entsprechendes Verfahren zum Betreiben einer Vorrichtung zum geschalteten Ansteuern von mehreren Lasten RL1 bis RLn. Die durch das Verfahren zu betreibende Vorrichtung umfasst Schaltelemente T1 bis Tn, einen Sternpunkt SP und ein Bezugspotenzial GND. Die Schaltelemente T1 bis Tn sind dazu eingerichtet und vorgesehen, jeweils eine oder mehrere Lasten RL1 bis RLn mit einer Versorgung V und/oder dem Sternpunkt SP zu verbinden und von diesen zu trennen. Das Verfahren umfasst die im Folgenden beschriebenen Schritte.-Ein erster Schritt betrifft das Erfassen des Stromes vom Sternpunkt SP zum Bezugspotenzial GND, bevorzugt mittels des besagten Strommessmittels Z_{g}. Es folgen auf Basis des so ermittelten Erfassungsergebnisses die Detektion von Flanken im Strom vom Sternpunkt SP zum Bezugspotenzial GND und die Erzeugung zugehöriger Informationen. Anschließende werden diese so erzeugten Informationen für den Betrieb der Vorrichtung verwendet.

Das so grob umrissene Verfahren kann dann weiter verfeinert werden. Besonders bevorzugt wird die besagte Information für die Steuerung der Schaltelemente verwendet.

In einer weiteren Ausgestaltung des Verfahrens hängt der Zeitpunkt eines Zustandswechsels eines der Schaltelemente T1 bis Tn von dieser Information ab. Beispielsweise kann die Kommutierung bzw. Ansteuerung eines Motors oder eines Netzteils oder eines Spannungsreglers eines Schaltnetzteils auf diese Weise geändert werden.

In einer weiteren Ausgestaltung des Verfahrens erfolgt eine Änderung des Erfassungszeitpunkts zumindest einer Flanke in der Art, dass sie infolge einer Wechselwirkung mit einer anderen Flanke nicht mehr detektierbar ist. Diese Änderung kann beispielsweise durch eine Verschiebung des Änderungszeitpunkts des Zustands eines Ansteuersignals G1 bis Gn der Schaltelemente T1 bis Tn geschehen.

Wie oben beschrieben, kann diese Information in einer anderen Ausgestaltung auch parallel und/oder alternativ dazu zum Erkennen eines Fehlerzustands verwendet werden.

Die Erfindung ermöglicht zum einen das rechtzeitige Erkennen sicherheitsrelevanter Ausfälle. Dies ist insbesondere im Falle der Elektromobilität sehr wichtig, da hier erhebliche Energien im Schadensfall erhebliche Gefahren hervorrufen können. Des Weiteren kann zum anderen die EMV-Abstrahlung signifikant verbessert werden. Die Vorteile sind hierauf aber nicht beschränkt.

### BEZUGSZEICHENLISTE

- A+: Ausgang des Flankendetektors für steigende Flanken
- A-: Ausgang des Flankendetektors für fallende Flanken
- ANA: Analyseeinheit
- ANS: Ansteuereinheit
- C: Kapazität des Hochpass (DC-Filter)
- CB: Kontrollbus
- CMP1: erster Komparator
- CMP2: zweiter Komparator
- CTR: Schaltsignalerzeugungseinheit für die n Schaltsignale der n Schalter bzw. Transistoren
- DEF: differenziertes Eingangssignal des Flankendetektors
- DIAG: Diagnoseblock
- EF: Eingang des Flankendetektors
- FD: Flankendetektor
- FDS: (z.B. Flanken-)Detektorsignal
- FV: Flankenverschiebungsblock
- G1: Ansteuersignal für das erste Schaltelement
- G2: Ansteuersignal für das zweite Schaltelement
- G3: Ansteuersignal für das dritte Schaltelement
- G4: Ansteuersignal für das vierte Schaltelement
- Gn: Ansteuersignal für das n-te Schaltelement
- GND: Bezugspotenzial
- IC: integrierte Schaltung
- LZW: Lastzweige
- ML: Messinduktivität
- MS: Strommesssignal
- OP1: Verstärker
- PA: Parallelschaltung
- Ref+: Referenzwert für die steigende Flanke
- Ref-: Referenzwert für die fallende Flanke
- R1, R2: Widerstandsteiler
- RL1: Last im ersten Lastzweig, die durch das erste Schalterelement geschaltet wird
- RL2: Last im zweiten Lastzweig, die durch das zweite Schalterelement geschaltet wird
- RL3: Last im dritten Lastzweig, die durch das dritte Schalterelement geschaltet wird
- RL4: Last im n-ten Lastzweig, die durch das vierte Schalterelement geschaltet wird
- RLn: Last im ersten Lastzweig, die durch das n-te Schalterelement geschaltet wird;
- SP: Sternpunkt der n Lastzweige
- Sh: Shunt-Widerstand
- T1: Schaltelement (Transistor) für den ersten
- T2: Schaltelement (Transistor) für den zweiten T3 Schaltelement (Transistor) für den dritten Lastzweig;
- T4: Schaltelement (Transistor) für den vierten Lastzweig
- Tn: Schaltelement (Transistor) für den n-ten Lastzweig;
- V: Versorgung (oder Versorgungsspannungsleitung mit Betriebsspannung gegenüber dem Bezugspotenzial)
- VER: elektrischer Verbraucher
- ZFV: Vorrichtung zur zeitlichen Verschiebung
- Z_{g}: gemeinsames Strommessmittel für alle n Lastzweige

### LITERATURVERZEICHNIS

DE-A 100 41 880
EP-A 0 198 222
DE-A 10 2020 033 633

## Patentansprüche

1. Vorrichtung zur Analyse von Strömen in einem elektrischen Verbraucher (VER), der versehen ist mit
- einer Parallelschaltung (PA) aus mehreren Lastzweigen (LZW),
- wobei jeder Lastzweig eine elektrische Last (RL1, RL2, ..., RLn) und ein diese wahlweise ein- oder ausschaltbares, steuerbares Schaltelement (T1, T2, ..., Tn) aufweist und
- einer Ansteuereinheit (ANS) zur Erzeugung von Ansteuersignalen für die Schaltelemente (T1, T2, ..., Tn),
wobei die Vorrichtung versehen ist mit
- einem in Reihe mit der Parallelschaltung (PA) der Lastzweige (LZW) des Verbrauchers (VER) verbindbaren Strommessmittel (Z_{g}) zum Messen eines die Parallelschaltung (PA) durchfließenden Stroms,
- einem Detektor (FD) zur Detektion einer Veränderung des Stroms beim Ein- oder Ausschalten oder infolge eines Einschaltens oder Ausschaltens des Schaltelements (T1, T2, ..., Tn) eines Lastzweiges (LZW) und
- einer mit dem Detektor (FD) verbundenen Analyseeinheit (ANA), die mit der Ansteuereinheit (ANS) verbindbar ist,
**dadurch gekennzeichnet,**
- **dass** die Analyseeinheit (ANA) die zeitliche Korrelation eines Ansteuersignals zum Einschalten oder zum Ausschalten eines Schaltelements (T1, T2, ..., Tn) eines Lastzweiges (LZW) mit der Detektion der Veränderung des Stroms infolge des Einschaltens und/oder des Ausschaltens des betreffenden Schaltelements (T1, T2, ..., Tn) analysiert.

2. Vorrichtung nach Anspruch 1, **dadurch gekennzeichnet, dass** die Analyseeinheit (ANA) eine Veränderung der zeitlichen Korrelation eines Ansteuersignals zum Einschalten oder zum Ausschalten eines Schaltelements (T1, T2, ..., Tn) eines Lastzweiges (LZW) mit der Detektion der Veränderung des Stroms infolge des Einschaltens und/oder des Ausschaltens des betreffenden Schaltelements (T1, T2, ..., Tn) analysiert.

3. Vorrichtung nach Anspruch 1, **dadurch gekennzeichnet, dass** die Analyseeinheit (ANA) auch die Veränderung des Stroms zu mehreren Zeitpunkten des Einschaltens und/oder des Ausschaltens eines betreffenden Schaltelements (T1, T2, ..., Tn) eines Lastzweiges (LZW) oder der Schaltelemente (T1, T2, ..., Tn) mehrerer und insbesondere aller Lastzweige (LZW) analysiert.

4. Vorrichtung nach Anspruch 3, **dadurch gekennzeichnet, dass** die Analyseeinheit (ANA) die Art der Veränderung des Stroms hinsichtlich des zeitlichen Verlaufs der Veränderung analysiert.

5. Vorrichtung nach Anspruch 4, **dadurch gekennzeichnet, dass** die Analyseeinheit (ANA) die mathematische Ableitung erster Ordnung und/oder zweiter Ordnung und/oder höherer Ordnung der Veränderung des Stroms und/oder das Integral über die Veränderung des Stroms und/oder die Größe und die Richtung der Veränderung des Stroms analysiert.

6. Vorrichtung nach den Ansprüchen 1 bis 5, **dadurch gekennzeichnet, dass** die Analyseeinheit (ANA) eine Datenverarbeitungseinheit aufweist, die auf der Grundlage einer Datenbank, in der Daten darüber abgelegt sind, welche den Betrieb des elektrischen Verbrauchers (VER) betreffende Ereignisse verschiedenen Ergebnissen der Analyse der Analyseeinheit (ANA) jeweils zuzuordnen sind, nach Art eines statistischen Modells Ansteuersignale für die Schaltelemente (T1, T2, ..., Tn) der Lastzweige (LZW) des elektrischen Verbrauchers oder für dessen Ansteuereinheit (ANS) bildet und/oder signalisiert, wenn eine von der Analyseeinheit (ANA) erstellte Analyse auf einen potenziellen oder tatsächlichen Fehler des elektrischen Verbrauchers (VER) hindeutet.

7. Vorrichtung nach Anspruch 6, **dadurch gekennzeichnet, dass** es sich bei dem statistischen Modell um ein HMM-Modell oder um ein künstliches neuronales Netzwerk handelt.

8. Vorrichtung nach den Ansprüchen 1 bis 7, **dadurch gekennzeichnet, dass** das Strommessmittel (Z_{g}) eine Messinduktivität (ML) aufweist und dass der Detektor (FD) eine Veränderung des Stroms als über oder an oder infolge der Messinduktivität (ML) entstehenden Störpuls mit Berücksichtigung von dessen Polarität detektiert.

9. Vorrichtung nach einem der Ansprüche 1 bis 8, **dadurch gekennzeichnet, dass** die Analyseeinheit (ANA) analysiert, ob ein Störpuls hinsichtlich seines Betrags größer ist als ein vorgegebener Minimalpegel und/oder innerhalb eines Bereichs zwischen einem vorgegebenen Minimalpegel und einem vorgegebenen Maximalpegel liegt.

10. Vorrichtung nach einem der Ansprüche 1 bis 9, **dadurch gekennzeichnet, dass** der Detektor (FD) als ein Flankendetektor zur Detektion der ansteigenden oder der abfallenden Flanke eines Störpulses über der Messinduktivität (ML) mit jeweils einem vorgegebenen Minimalpegel ausgebildet ist.

11. Vorrichtung nach einem der Ansprüche 1 bis 10, **dadurch gekennzeichnet, dass** das Strommessmittel (Z_{g}) als Shunt-Widerstand (Sh) ausgebildet ist, der als parasitäre Komponente eine Induktivität aufweist.

12. Vorrichtung nach einem der Ansprüche 1 bis 11, **dadurch gekennzeichnet, dass** die Analyseeinheit (ANA) analysiert, ob auf das Einschalten des Schaltelements (T1, T2, ..., Tn) eines der Lastzweige (LZW) innerhalb eines vorgegebenen Zeitfensters ein Störpuls mit positiver Polarität und/oder auf das Ausschalten des Schaltelements (T1, T2, ..., Tn) eines der Lastzweige (LZW) innerhalb eines vorgegebenen Zeitfensters ein Störpuls mit negativer Polarität folgt.

13. Vorrichtung nach einem der Ansprüche 1 bis 12, **dadurch gekennzeichnet, dass** die Analyseeinheit (ANA) eine Diagnosekomponente aufweist, die eine Fehlermeldung generiert, sofern auf das Einschalten des Schaltelements (T1, T2, ..., Tn) eines der Lastzweige (LZW) innerhalb eines vorgegebenen Zeitfensters kein Störpuls mit positiver Polarität und/oder auf das Ausschalten des Schaltelements (T1, T2, ..., Tn) eines der Lastzweige (LZW) innerhalb eines vorgegebenen Zeitfensters kein Störpuls mit negativer Polarität folgt.

14. Vorrichtung nach einem der Ansprüche 1 bis 13, **dadurch gekennzeichnet, dass** dann, wenn die Ansteuereinheit (ANS) für die Schaltelemente (T1, T2, ..., Tn) der Lastzweige (LZW) des elektrischen Verbrauchers (VER) die Schaltelemente (T1, T2, ..., Tn) jeweils zweier Lastzweige (LZW) derart ansteuert, dass das Ausschalten des Schaltelements (T1, T2, ..., Tn) des einen Lastzweiges (LZW) zeitgleich mit dem Einschalten des Schaltelements (T1, T2, ..., Tn) des anderen Lastzweiges (LZW) erfolgt, die Auswerteeinheit (DIAG) analysiert, ob auf das Einschalten des Schaltelements (T1, T2, ..., Tn) des einen Lastzweiges (LZW) innerhalb eines vorgegebenen Zeitfensters kein Störpuls und/oder auf das Ausschalten des Schaltelements (T1, T2, ..., Tn) des anderen Lastzweiges (LZW) innerhalb eines vorgegebenen Zeitfensters kein Störpuls folgt.

15. Vorrichtung nach einem der Ansprüche 1 bis 14, **dadurch gekennzeichnet, dass** dann, wenn auf das Einschalten des Schaltelements (T1, T2, ..., Tn) eines der Lastzweige (LZW) innerhalb eines vorgegebenen Zeitfensters ein Störpuls mit positiver Polarität und/oder auf das Ausschalten des Schaltelements (T1, T2, ..., Tn) eines der Lastzweige (LZW) innerhalb eines vorgegebenen Zeitfensters ein Störpuls mit negativer Polarität folgt, die Analyseeinheit (ANA) die Schaltelement-Ansteuereinheit (ANS) zur zeitlichen Verschiebung der Ansteuersignale zwecks zeitgleichen, wechselweisen Ein- und Ausschaltens sowie Aus- und Einschaltens der Schaltelemente (T1, T2, ..., Tn) der jeweils zwei Lastzweige (LZW) des elektrischen Verbrauchers (VER) steuert.

16. Vorrichtung nach einem der Ansprüche 1 bis 15, **dadurch gekennzeichnet, dass** das Einschalt-Ansteuersignal der Ansteuereinheit (ANS) zum Einschalten des Schaltelements (T1, T2, ..., Tn) eines Lastzweiges (LZW) eine ansteigende Schaltflanke aufweist und dass das Ausschalt-Ansteuersignal der Ansteuereinheit (ANS) für das Ausschalten des Schaltelements eines Lastzweiges (LZW) eine abfallende Schaltflanke aufweist.

17. Vorrichtung nach Anspruch 15 und 16, **dadurch gekennzeichnet, dass** die Schaltelement-Ansteuereinheit (ANS) eine Vorrichtung zur zeitlichen Verschiebung (ZFV) der ansteigenden Flanke des Einschaltansteuersignals und/oder zur zeitlichen Verschiebung der abfallenden Flanke des Ausschaltansteuersignals aufweist.

18. Vorrichtung nach einem der Ansprüche 1 bis 17, **dadurch gekennzeichnet, dass** die Schaltelemente (T1, T2, ..., Tn) der Lastzweige (LZW) des elektrischen Verbrauchers (VER) Teil der Vorrichtung sind.

19. Elektrischer Verbraucher (VER), mit
- einer Parallelschaltung (PA) aus mehreren Lastzweigen (LZW),
- wobei jeder Lastzweig eine elektrische Last (RL1, RL2, ..., RLn) und ein diese wahlweise ein- oder ausschaltbares, steuerbares Schaltelement (T1, T2, ..., Tn) aufweist,
- einer Ansteuereinheit (ANS) zur Erzeugung von Ansteuersignalen für die Schaltelemente (T1, T2, ..., Tn) und
- eine Vorrichtung zur Analyse von Strömen nach einem der vorhergehenden Ansprüche.

## Claims

1. A device for analyzing currents in an electrical consumer (VER), which is provided with
- a parallel circuit (PA) consisting of several load branches (LZW),
- each load branch having an electrical load (RL1, RL2, ..., RLn) and a controllable switching element (T1, T2, ..., Tn) which can selectively switch on or off the electrical load, and
- a control unit (ANS) for generating control signals for the switching elements (T1, T2, ..., Tn),
wherein the device is provided with
- a current measuring means (Z_{g}) which can be connected in series with the parallel circuit (PA) of the load branches (LZW) of the consumer (VER) for measuring a current flowing through the parallel circuit (PA),
- a detector (FD) for detecting a change in the current when switching on or switching off or as a result of switching on or off the switching element (T1, T2, ..., Tn) of a load branch (LZW), and
- an analysis unit (ANA) connected to the detector (FD), which can be connected to the control unit (ANS),
**characterized in that**
- the analysis unit (ANA) analyzes the temporal correlation of a control signal for switching on or switching off a switching element (T1, T2, ..., Tn) of a load branch (LZW) with the detection of the change in current as a result of the switching on and/or switching off of the respective switching element (T1, T2, ..., Tn).

2. The device according to claim 1, **characterized in that** thee analysis unit (ANA) analyzes a change in temporal correlation of a control signal for switching on or switching off a switching element (T1, T2, ..., Tn) of a load branch (LZW) with the detection of the change in current as a result of the switching on and/or switching off of the respective switching element (T1, T2, ..., Tn).

3. The device according to claim 1, **characterized in that** the analysis unit (ANA) also analyses the change in the current at several points in time of the switching on and/or switching off of a respective switching element (T1, T2, ..., Tn) of a load branch (LZW) or of the switching elements (T1, T2, ..., Tn) of several and in particular all load branches (LZW).

4. The device according to claim 3, **characterized in that** the analysis unit (ANA) analyses the type of the change in the current with regard to the temporal course of the change.

5. The device according to claim 4, **characterized in that** the analysis unit (ANA) analyses the first-order and/or second-order and/or higher-order mathematical derivation of the change in the current and/or the integral over the change in the current and/or the magnitude and direction of the change in the current.

6. The device according to claims 1 to 5, **characterized in that** the analysis unit (ANA) has a data processing unit which, on the basis of a database in which data are stored about which events relating to the operation of the electrical load (VER) are respectively to be assigned to different results of the analysis of the analysis unit (ANA), forms control signals in the manner of a statistical model for the switching elements (T1, T2, ..., Tn) of the load branches (LZW) of the electrical consumer or for its control unit (ANS) and/or signalizes if an analysis created by the analysis unit (ANA) indicates a potential or actual fault of the electrical consumer (VER).

7. The device according to claim 6, **characterized in that** the statistical model is an HMM model or an artificial neural network.

8. The device according to claims 1 to 7, **characterized in that** the current measuring means (Z_{g}) has a measuring inductance (ML) and **in that** the detector (FD) detects a change in the current as an interference pulse arising above or at or as a result of the measuring inductance (ML), taking into account its polarity.

9. The device according to any one of claims 1 to 8, **characterized in that** the analysis unit (ANA) analyses whether an interference pulse is greater than a predetermined minimum level in terms of its magnitude and/or is within a range between a predetermined minimum level and a predetermined maximum level.

10. The device according to any one of claims 1 to 9, **characterized in that** the detector (FD) is configured as an edge detector for detecting the rising or falling edge of an interference pulse via the measuring inductance (ML) with respectively one predetermined minimum level.

11. The device according to any one of claims 1 to 10, **characterized in that** the current measuring means (Z_{g}) is configured as a shunt resistor (Sh) which has an inductance as a parasitic component.

12. The device according to any one of claims 1 to 11, **characterized in that** the analysis unit (ANA) analyses whether the switching on of the switching element (T1, T2, ..., Tn) of one of the load branches (LZW) within a predetermined time window is followed by an interference pulse with positive polarity and/or the switching off of the switching element (T1, T2, ..., Tn) of one of the load branches (LZW) within a predetermined time window is followed by an interference pulse with negative polarity.

13. The device according to any one of claims 1 to 12, **characterized in that** the analysis unit (ANA) comprises a diagnostic component which generates an error message analyses if the switching on of the switching element (T1, T2, ..., Tn) of one of the load branches (LZW) within a predetermined time window is not followed by an interference pulse with positive polarity and/or the switching off of the switching element (T1, T2, ..., Tn) of one of the load branches (LZW) within a predetermined time window is not followed by an interference pulse with negative polarity.

14. The device according to any one of claims 1 to 13, **characterized in that**, when the control unit (ANS) for the switching elements (T1, T2, ..., Tn) of the load branches (LZW) of the electrical consumer (VER) controls the switching elements (T1, T2, .., Tn) of respectively two load branches (LZW) in such a way that the switching off of the switching element (T1, T2, ..., Tn) of the one load branch (LZW) occurs at the same time as the switching on of the switching element (T1, T2, ..Tn) of the other load branch (LZW), the evaluation unit (DIAG) analyzes whether the switching on of the switching element (T1, T2, ..., Tn) of the one load branch (LZW) is not followed by an interference pulse within a predefined time window and/or the switching off of the switching element (T1, T2, ..., Tn) of the other load branch (LZW) is not followed by an interference pulse within a predefined time window.

15. The device according to any one of claims 1 to 14, **characterized in that** if the switching on of the switching element (T1, T2, ..., Tn) of one of the load branches (LZW) is followed within a predetermined time window by an interference pulse with positive polarity and/or the switching off of the switching element (T1, T2, .., Tn) of one of the load branches (LZW) is followed by an interference pulse with negative polarity within a predetermined time window, the analysis unit (ANA) controls the switching element control unit (ANS) for time shifting of the control signals for the purpose of simultaneous, alternating switching on and off and switching off and on the switching elements (T1, T2, ..., Tn) of the respectively two load branches (LZW) of the electrical consumer (VER).

16. The device according to any one of claims 1 to 15, **characterized in that** the switch-on control signal of the control unit (ANS) for switching on the switching element (T1, T2, ..., Tn) of a load branch (LZW) has a rising switching edge and **in that** the switch-off control signal of the control unit (ANS) for switching off the switching element of a load branch (LZW) has a falling switching edge.

17. The device according to claims 15 and 16, **characterized in that** the switching element control unit (ANS) has a device for time shifting (ZFV) the rising edge of the switch-on control signal and/or for time shifting the falling edge of the switch-off control signal.

18. The device according to any one of claims 1 to 17, **characterized in that** the switching elements (T1, T2, ..., Tn) of the load branches (LZW) of the electrical consumer (VER) are part of the device.

19. An electrical consumer (VER), comprising
- a parallel circuit (PA) consisting of several load branches (LZW),
- each load branch having an electrical load (RL1, RL2, ..., RLn) and a controllable switching element (T1, T2, ..., Tn) which can selectively be switched on or off,
- a control unit (ANS) for generating control signals for the switching elements (T1, T2, ..., Tn), and
- a device for analyzing currents according to one of the preceding claims.

## Revendications

1. Dispositif d'analyse des courants dans un consommateur électrique (VER) qui comprend
- un montage en parallèle (PA) de plusieurs branches de charge (LZW),
- chaque branche de charge comportant une charge électrique (RL1, RL2, ..., RLn) et un élément de commutation commandable (T1, T2, ..., Tn) apte à la mettre en circuit ou hors circuit, au choix, et
- une unité de commande (ANS) pour générer des signaux de commande pour les éléments de commutation (T1, T2, ..., Tn),
le dispositif comprenant
- un moyen de mesure de courant (Z_{g}) apte à être connecté en série avec le montage en parallèle (PA) des branches de charge (LZW) du consommateur (VER) pour mesurer un courant traversant le montage en parallèle (PA),
- un détecteur (FD) pour détecter une variation du courant lors de la mise en circuit ou de la mise hors circuit ou à la suite d'une mise en circuit ou d'une mise hors circuit de l'élément de commutation (T1, T2, Tn) d'une branche de charge (LZW) et
- une unité d'analyse (ANA) connectée au détecteur (FD), laquelle peut être connectée à l'unité de commande (ANS),
**caractérisé en ce que**
- l'unité d'analyse (ANA) analyse la corrélation temporelle d'un signal de commande pour la mise en circuit ou hors circuit d'un élément de commutation (T1, T2, ..., Tn) d'une branche de charge (LZW) avec la détection de la variation du courant à la suite de la mise en circuit et/ou de la mise hors circuit de l'élément de commutation concerné (T1, T2, ..., Tn).

2. Dispositif selon la revendication 1,
**caractérisé en ce que** l'unité d'analyse (ANA) analyse une variation de la corrélation temporelle d'un signal de commande pour la mise en circuit ou hors circuit d'un élément de commutation (T1, T2, ..., Tn) d'une branche de charge (LZW) avec la détection de la variation du courant à la suite de la mise en circuit et/ou de la mise hors circuit de l'élément de commutation concerné (T1, T2, ..., Tn).

3. Dispositif selon la revendication 1,
**caractérisé en ce que** l'unité d'analyse (ANA) analyse également la variation du courant à plusieurs instants de la mise en circuit et/ou de la mise hors circuit d'un élément de commutation concerné (T1, T2, ..., Tn) d'une branche de charge (LZW) ou des éléments de commutation (T1, T2, ..., Tn) de plusieurs et en particulier de toutes les branches de charge (LZW).

4. Dispositif selon la revendication 3,
**caractérisé en ce que** l'unité d'analyse (ANA) analyse le type de variation du courant en ce qui concerne l'évolution temporelle de la variation.

5. Dispositif selon la revendication 4,
**caractérisé en ce que** l'unité d'analyse (ANA) analyse la dérivée mathématique du premier ordre et/ou du deuxième ordre et/ou d'un ordre supérieur de la variation du courant et/ou l'intégrale de la variation du courant et/ou l'amplitude et le sens de la variation du courant.

6. Dispositif selon les revendications 1 à 5,
**caractérisé en ce que** l'unité d'analyse (ANA) possède une unité de traitement de données qui, sur la base d'une base de données contenant des données stockées indiquant quels événements, relatifs au fonctionnement du consommateur électrique (VER), sont à affecter à différents résultats de l'analyse par l'unité d'analyse (ANA), forme et/ou émet, à la manière d'un modèle statistique, des signaux de commande pour les éléments de commutation (T1, T2, ..., Tn) des branches de charge (LZW) du consommateur électrique ou pour son unité de commande (ANS) si une analyse créée par l'unité d'analyse (ANA) indique un défaut potentiel ou réel du consommateur électrique (VER).

7. Dispositif selon la revendication 6,
**caractérisé en ce que** le modèle statistique est un modèle MMC ou un réseau neuronal artificiel.

8. Dispositif selon les revendications 1 à 7,
**caractérisé en ce que** le moyen de mesure de courant (Z_{g}) comporte une inductance de mesure (ML), et **en ce que** le détecteur (FD) détecte une variation du courant sous la forme d'une impulsion parasite générée au-dessus, au niveau ou à la suite de l'inductance de mesure (ML), en tenant compte de sa polarité.

9. Dispositif selon l'une des revendications 1 à 8,
**caractérisé en ce que** l'unité d'analyse (ANA) analyse si une impulsion parasite présente une valeur absolue supérieure à un niveau minimal prédéfini et/ou se situe dans une plage comprise entre un niveau minimal prédéfini et un niveau maximal prédéfini.

10. Dispositif selon l'une des revendications 1 à 9,
**caractérisé en ce que** le détecteur (FD) est conçu comme un détecteur de front pour détecter le front montant ou descendant d'une impulsion parasite au-dessus de l'inductance de mesure (ML) avec un niveau minimal prédéfini respectif.

11. Dispositif selon l'une des revendications 1 à 10,
**caractérisé en ce que** le moyen de mesure de courant (Z_{g}) est conçu comme une résistance shunt (Sh) qui présente une inductance comme composant parasitaire.

12. Dispositif selon l'une des revendications 1 à 11,
**caractérisé en ce que** l'unité d'analyse (ANA) analyse si la mise en circuit de l'élément de commutation (T1, T2, ..., Tn) de l'une des branches de charge (LZW) est suivie, dans un intervalle de temps prédéfini, d'une impulsion parasite de polarité positive et/ou si la mise hors circuit de l'élément de commutation (T1, T2, ..., Tn) de l'une des branches de charge (LZW) est suivie, dans un intervalle de temps prédéfini, d'une impulsion parasite de polarité négative.

13. Dispositif selon l'une des revendications 1 à 12,
**caractérisé en ce que** l'unité d'analyse (ANA) comporte un composant de diagnostic qui génère un message d'erreur si la mise en circuit de l'élément de commutation (T1, T2, ..., Tn) de l'une des branches de charge (LZW) n'est pas suivie d'une impulsion parasite de polarité positive dans un intervalle de temps prédéfini et/ou si la mise hors circuit de l'élément de commutation (T1, T2, ..., Tn) de l'une des branches de charge (LZW) n'est pas suivie d'une impulsion parasite de polarité négative dans un intervalle de temps prédéfini.

14. Dispositif selon l'une des revendications 1 à 13,
**caractérisé en ce que**, lorsque l'unité de commande (ANS) pour les éléments de commutation (T1, T2, ..., Tn) des branches de charge (LZW) du consommateur électrique (VER) commande les éléments de commutation (T1, T2, ..., Tn) de deux branches de charge (LZW) respectives de telle sorte que la mise hors circuit de l'élément de commutation (T1, T2, ..., Tn) de l'une des branches de charge (LZW) s'effectue simultanément avec la mise en circuit de l'élément de commutation (T1, T2, ..., Tn) de l'autre branche de charge (LZW), l'unité d'évaluation (DIAG) analyse si la mise en circuit de l'élément de commutation (T1, T2, ..., Tn) de la première branche de charge (LZW) n'est suivie d'aucune impulsion parasite dans un intervalle de temps prédéfini et/ou si la mise hors circuit de l'élément de commutation (T1, T2, ..., Tn) de l'autre branche de charge (LZW) n'est suivie d'aucune impulsion parasite dans un intervalle de temps prédéfini.

15. Dispositif selon l'une des revendications 1 à 14,
**caractérisé en ce que**, si la mise en circuit de l'élément de commutation (T1, T2, ..., Tn) de l'une des branches de charge (LZW) est suivie d'une impulsion parasite de polarité positive dans un intervalle de temps prédéfini et/ou si la mise hors circuit de l'élément de commutation (T1, T2, ..., Tn) de l'une des branches de charge (LZW) est suivie d'une impulsion parasite de polarité négative dans un intervalle de temps prédéfini, l'unité d'analyse (ANA) commande l'unité de commande (ANS) des éléments de commutation pour décaler dans le temps les signaux de commande en vue d'une mise en circuit et d'une mise hors circuit et d'une mise hors circuit et d'une mise en circuit simultanées et alternatives des éléments de commutation (T1, T2, ..., Tn) des deux branches de charge (LZW) respectives du consommateur électrique (VER).

16. Dispositif selon l'une des revendications 1 à 15,
**caractérisé en ce que** le signal de commande de mise en circuit de l'unité de commande (ANS) pour la mise en circuit de l'élément de commutation (T1, T2, ..., Tn) d'une branche de charge (LZW) présente un front montant, et **en ce que** le signal de commande de mise hors circuit de l'unité de commande (ANS) pour la mise hors circuit de l'élément de commutation d'une branche de charge (LZW) présente un front descendant.

17. Dispositif selon les revendications 15 et 16,
**caractérisé en ce que** l'unité de commande (ANS) des éléments de commutation comporte un dispositif pour le décalage dans le temps (ZFV) du front montant du signal de commande de mise en circuit et/ou pour le décalage dans le temps du front descendant du signal de commande de mise hors circuit.

18. Dispositif selon l'une des revendications 1 à 17,
**caractérisé en ce que** les éléments de commutation (T1, T2, ..., Tn) des branches de charge (LZW) du consommateur électrique (VER) font partie du dispositif.

19. Consommateur électrique (VER), comprenant
- un montage en parallèle (PA) de plusieurs branches de charge (LZW),
- chaque branche de charge comportant une charge électrique (RL1, RL2, ..., RLn) et un élément de commutation commandable (T1, T2, ..., Tn) apte à la mettre en circuit ou hors circuit, au choix, et
- une unité de commande (ANS) pour générer des signaux de commande pour les éléments de commutation (T1, T2, ..., Tn), et
- un dispositif d'analyse des courants selon l'une des revendications précédentes.
